# EUROPÄISCHE PATENTANMELDUNG

(11) **EP 0 971 414 A1**
(43) Veröffentlichungstag der Anmeldung: **12.01.2000**
(21) Anmeldenummer: 98110933.3
(22) Anmeldetag: 15.06.1998
(51) Int. Cl.: H01L 27/108, H01L 21/8242

(54) **Grabenkondensator mit Isolationskragen und vergrabenen Kontakt und entsprechendes Herstellungsverfahren**

(71) Anmelder: SIEMENS AKTIENGESELLSCHAFT, 80333 München (DE)
(72) Erfinder: Schrems, Martin, 01465 Langebrück (DE); Morhard, Klaus-Dieter, 01099 Dresden (DE); Wurster, Kai, 01099 Dresden (DE); Lamprecht, Alexandra, 01099 Dresden (DE); Faul, Jürgen, 01445 Radebeul (DE); Dequiedt, Odile, 01097 Dresden (DE)

(57) **Zusammenfassung**

Die vorliegende Erfindung schafft einen Grabenkondensator, insbesondere zur Verwendung in einer Halbleiter-Speicherzelle (100), mit einem Isolationskragen (168) mit einem Graben (108), der in einem Substrat (101) gebildet ist; dem Isolationskragen (168), der im oberen Bereich des Grabens (108) gebildet ist; einer optionellen vergrabenen Platte (165) im Substratbereich in der Umgebung des unteren Bereichs des Grabens (108) als erste Kondensatorplatte; einer dielektrischen Schicht (164) zur Verkleidung des unteren Bereichs des Grabens (108) und des Isolationskragens (168) als Kondensatordielektrikum; einem in den Graben (108) gefüllten leitenden zweiten Füllmaterial (161) als zweite Kondensatorplatte und einem vergrabenen Kontakt unterhalb der Oberfläche des Substrats (101); wobei das Substrat (101) unterhalb seiner Oberfläche im Bereich des vergrabenen Kontakts einen durch Implantation, Plasmadotierung und/oder Gasphasenabscheidung eingebrachten Dotierbereich (250; 250') aufweist. Vorzugsweise wird an der Grenzfläche (201) des vergrabenen Kontakts eine Tunnelschicht, insbesondere eine Oxid-, Nitrid- oder Oxinitridschicht, gebildet.

## Beschreibung

Die vorliegende Erfindung betrifft einen Grabenkondensator mit einem Isolationskragen und ein entsprechendes Herstellungsverfahren.

Obwohl auf beliebige Grabenkondensatoren anwendbar, werden die vorliegende Erfindung und die ihr zugrundeliegende Problematik nachstehend in bezug auf einen in einer DRAM-Speicherzelle verwendeten Grabenkondensator erläutert. Solche Speicherzellen werden in integrierten Schaltungen (ICs), wie beispielsweise Speichern mit wahlfreiem Zugriff (RAMs), dynamischen RAMs (DRAMs), synchronen DRAMs (SDRAMs), statischen RAMs (SRAMs) und Nur-Lese-Speichern (ROMs) verwendet. Andere integrierte Schaltungen enthalten Logikvorrichtungen, wie z.B. programmierbare Logikarrays (PLAs), anwenderspezifische ICs (ASICs), Mischlogik/ Speicher-ICs (eingebettete DRAMs) oder sonstige Schaltungsvorrichtungen. Üblicherweise wird eine Vielzahl von ICs auf einem Halbleitersubstrat, wie z.B. einem Siliziumwafer, parallel hergestellt. Nach der Verarbeitung wird der Wafer zerteilt, um die ICs in eine Vielzahl individueller Chips zu separieren. Die Chips werden dann in Endprodukte verpackt, beispielsweise zur Verwendung in Verbraucherprodukten, wie z.B. Computersystemen, zellulären Telefonen, persönlichen digitalen Assistenten (PDAs) und weiteren Produkten. Zu Diskussionszwecken wird die Erfindung hinsichtlich der Bildung einer einzelnen Speicherzelle beschrieben.

Integrierte Schaltungen (ICs) oder Chips verwenden Kondensatoren zum Zwecke der Ladungsspeicherung. Ein Beispiel eines IC, welcher Kondensatoren zum Speichern von Ladungen verwendet, ist ein Speicher-IC, wie z.B. ein Chip für einen dynamischen Schreib-/Lesespeicher mit wahlfreiem Zugriff (DRAM). Der Ladungszustand ("0" oder "1") in dem Kondensator repräsentiert dabei ein Datenbit.

Ein DRAM-Chip enthält eine Matrix von Speicherzellen, welche in Form von Zeilen und Spalten verschaltet sind. Üblicherweise werden die Zeilenverbindungen als Wortleitungen und die Spaltenverbindungen als Bitleitungen bezeichnet. Das Auslesen von Daten von den Speicherzellen oder das Schreiben von Daten in die Speicherzellen wird durch die Aktivierung geeigneter Wortleitungen und Bitleitungen bewerkstelligt.

Üblicherweise enthält eine DRAM-Speicherzelle einen mit einem Kondensator verbundenen Transistor. Der Transistor enthält zwei Diffusionsbereiche, welche durch einen Kanal getrennt sind, oberhalb dessen ein Gate angeordnet ist. Abhängig von der Richtung des Stromflusses bezeichnet man den einen Diffusionsbereich als Drain und den anderen als Source. Die Bezeichnungen "Drain" und "Source" werden hier hinsichtlich der Diffusionsbereiche gegenseitig austauschbar verwendet. Die Gates sind mit einer Wortleitung verbunden, und einer der Diffusionsbereiche ist mit einer Bitleitung verbunden. Der andere Diffusionsbereich ist mit dem Kondensator verbunden. Das Anlegen einer geeigneten Spannung an das Gate schaltet den Transistor ein, ermöglicht einen Stromfluß zwischen den Diffusionsbereichen durch den Kanal, um so eine Verbindung zwischen dem Kondensator und der Bitleitung zu bilden. Das Ausschalten des Transistors trennt diese Verbindung, indem der Stromfluß durch den Kanal unterbrochen wird.

Die in dem Kondensator gespeicherte Ladung baut sich mit der Zeit aufgrund eines inhärenten Leckstroms ab. Bevor sich die Ladung auf einen unbestimmten Pegel (unterhalb eines Schwellwerts) abgebaut hat, muß der Speicherkondensator aufgefrischt werden.

Das fortlaufende Bestreben nach Verkleinerung der Speichervorrichtungen fördert den Entwurf von DRAMs mit größerer Dichte und kleinerer charakteristischer Größe, d.h. kleinerer Speicherzellenfläche. Zur Herstellung von Speicherzellen, welche eine geringeren Oberflächenbereich besetzen, werden kleinere Komponenten, beispielsweise Kondensatoren, verwendet. Jedoch resultiert die Verwendung kleinerer Kondensatoren in einer erniedrigten Speicherkapazität, was wiederum die Funktionstüchtigkeit und Verwendbarkeit der Speichervorrichtung widrig beeinflussen kann. Beispielsweise erfordern Leseverstärker einen ausreichenden Signalpegel zum zuverlässigen Auslesen der Information in den Speicherzellen. Das Verhältnis der Speicherkapazität zur Bitleitungskapazität ist entscheidend bei der Bestimmung des Signalpegels. Falls die Speicherkapazität zu gering wird, kann dieses Verhältnis zu klein zur Erzeugung eines hinreichenden Signals sein. Ebenfalls erfordert eine geringere Speicherkapazität eine höhere Auffrischfrequenz.

Ein Kondensatortyp, welcher üblicherweise in DRAMs verwendet wird, ist ein Grabenkondensator. Ein Grabenkondensator hat eine dreidimensionale Struktur, welche in dem Siliziumsubstrat ausgebildet ist. Eine Erhöhung des Volumens bzw. der Kapazität des Grabenkondensators kann durch tieferes Ätzen in das Substrat erreicht werden. In diesem Fall beweirkt die Steigerung der Kapazität des Grabenkondensators keine Vergrößerung der von der Speicherzelle belegte Oberfläche.

Ein üblicher Grabenkondensator enthält einen in das Substrat geätzten Graben. Dieser Graben wird typischerweise mit n⁺-dotiertem Polysilizium gefüllt, welches als eine Kondensatorelektrode dient (auch als Speicherkondensator bezeichnet). Optionellerweise wird eine zweite Kondensatorelektrode (auch als "vergrabene Platte" bezeichnet) durch Ausdiffundieren von n⁺-Dotierstoffen von einer Dotierstoffquelle in einen Bereich des Substrats, welcher den unteren Abschnitts des Grabens umgibt, gebildet. Ein n⁺-dotiertes Silikatglas, wie z.B. ein mit Arsen dotiertes Silikatglas (ASG), dient dabei als die Dotierstoffquelle. Ein Speicherdielektrikum, welches Nitrid enthält, wird üblicherweise zur Isolation der zwei Kondensatorelektroden verwendet.

In dem oberen Bereich des Grabens wird ein dielektrischer Kragen erzeugt, um einen Leckstrom von dem Kondensatoranschluß mit der vergrabenen Platte zu verhindern. Das Speicherdielektrikum in dem oberen Bereich des Grabens, wo der Kragen zu bilden ist, wird vor dessen Bildung entfernt. Die Entfernung des Nitrids verhindert einen vertikalen Leckstrom entlang des Kragens.

Jedoch schafft die Entfernung des oberen Bereichs der Nitridschicht Pinholes bzw. Nadellöcher am Übergang zwischen dem unteren Teil des Kragens und dem oberen Teil des Speicherdielektrikums. Solche Pinholes verschlechtern die Qualität des Speicherdielektrikums und sind eine wesentliche Quelle für den Ladungsabbau aus dem Graben. Dies reduziert die Haltezeit des Grabenkondensators und beeinträchtigt somit seine Funktionstüchtigkeit.

Zur Verhinderung der Bildung von Pinholes wurde ein zweistufiger Grabenätzprozeß vorgeschlagen. Dabei wird zunächst der Graben teilweise durch reaktives Ionenätzen (RIE) bis zur Tiefe des Kragens geätzt. Das reaktive Ionenätzen ist selektiv bezüglich der verwendeten Ätz-Hartmaske. Die üblicherweise für das reaktive Ionenätzen verwendeten Chemikalien umfassen beispielsweise NF₃/HBr/He/O₂. Eine Oxidschicht wird dann abgeschieden und derart geätzt, daß sie den Kragen auf den Grabenseitenwänden bildet. Die reaktive Ionenätzung ist hinsichtlich Silizium selektiv, wenn beispielsweise die Chemikalien CHF₃/He/O₂, CHF₃/Ar, C₄F₈/Ar oder CF₄ verwendet werden. Der übrige Bereich des Grabens wird nach der Kragenbildung geätzt. Das Speicherdielektrikum wird dann über dem Kragen und dem unteren Bereich der Grabenseitenwände gebildet. Dieses Verfahren eliminiert die Notwendigkeit der Beseitigung des oberen Bereichs des Speicherdielektrikums und somit die Bildung von Pinholes.

Obwohl solch eine zweistufige Grabenbildung hilfreich für die Verhinderung von Pinholes ist, kann der zweite reaktive Ionenätzschritt zum Entfernen von Silizium eine übermäßige Erosion des Kragens verursachen. Solch eine Verschlechterung des Kragens bewirkt das Auftreten von Leckströmen. Weiterhin dient der Kragen als eine Ätz-Hartmaske für den zweiten reaktiven Ionenätzschritt zur Herstellung des Grabens, welcher einen unteren Abschnitt des Grabens mit einem Durchmesser schafft, der gleich dem Innendurchmesser des Kragens ist. Somit ist der untere Bereich des Grabens kleiner als der obere Bereich, welcher einen Durchmesser aufweist, der etwa gleich dem Außendurchmesser des Kragens ist. Dies ist unerwünscht, da somit die Kapazität des Kondensators reduziert ist.

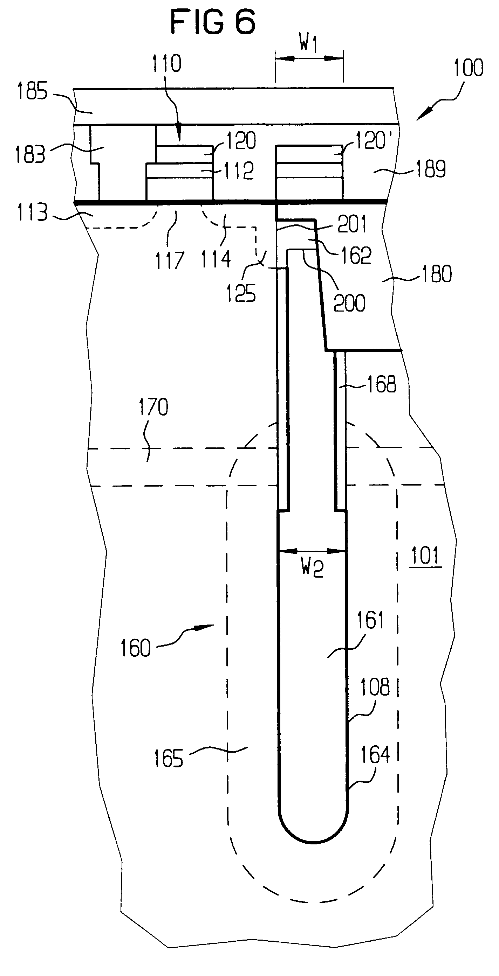

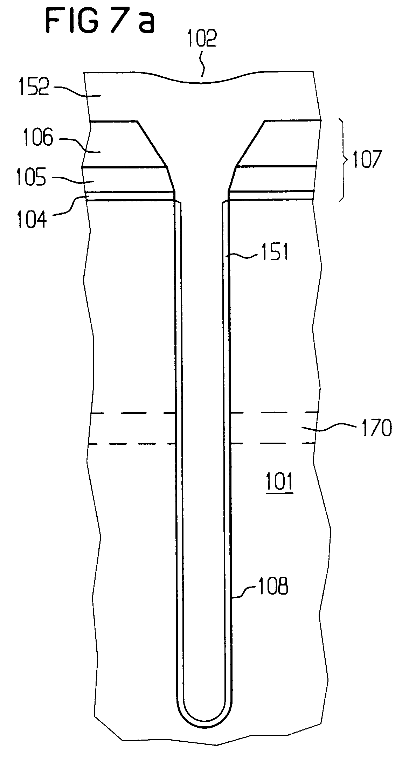

Mit Bezug auf Fig. 6 wird nun eine übliche DRAM-Zelle und mit Bezug auf Fig. 7a-g eine Variante des Verfahrens zur Herstellung der DRAM-Speicherzelle nach Fig. 6 beschrieben.

Der Grabenkondensator nach Fig. 6 enthält ein Speicherdielektrikum 164, welches stufenförmig über dem Kragen 168 gebildet ist, was die Notwendigkeit der Entfernung des oberen Bereichs der Speicherdielektrikumschicht eliminiert. Dies vermeidet die Bildung von Nadellöchern am Übergang des Kragens und des oberen Randes der Speicherdielektrikumschicht. Zusätzlicherweise hat der untere Bereich des Grabens eine Breite bzw. einen Durchmesser W₂, der zumindest gleich groß ist wie die Breite bzw. der Durchmesser W₁ des oberen Bereichs. Demgemäß lassen sich reduzierte Leckströme und eine erhöhte Kapazität erzielen.

Fig. 6 zeigt den Grabenkondensator 160, der in einer DRAM-Speicherzelle 100 implementiert ist. Ohne Beschränkung der Allgemeinheit ist die DRAM-Speicherzelle 100 eine MINT-Zelle (MINT = merged isolation node trench) mit einer vergrabenen Brücke 162 (Buried Strap). Andere Zellkonfigurationen, wie z.B. diejenigen, die eine an der Oberfläche liegende Brücke verwenden, sind ebenfalls verwendbar. Die typischen Dimensionen eines Grabens 108, welcher beispielsweise in einem 256 Mb-DRAM-Chip unter Verwendung von 0,25 µm-Designregeln implementiert ist, betragen etwa 7-8 µm Tiefe, und zwar mit einer Grabenöffnung von etwa 0,25 µm mal 0,50 µm.

Wie in Fig. 6 gezeigt, ist der Grabenkondensator 160 im Substrat 101 gebildet. Das Substrat ist beispielsweise mit Dotierstoffen eines ersten Leitungstyps leicht dotiert. Bei dieser Variante ist das Substrat 101 leicht mit p-Typ-Dotierstoffen (p⁻), wie z.B. B, dotiert. Die Verwendung eines stark dotierten p-Typ-Substrats (p⁺) ist ebenfalls möglich. Beispielsweise können epitaktisch hergestellte p⁺/p⁻-Substrate verwendet werden. Solche Substrate haben eine Dotierstoffkonzentration von etwa 10¹⁹ cm⁻³ mit einer p⁻-Epitaxieschicht von typischerweise 2-3 µm Dicke. Die Konzentration von B beträgt etwa 1,5 x 10¹⁶ cm⁻³. Eine (nicht gezeigte) p-Typ-Wanne ist zur Isolierung der Matrixvorrichtungen vorgesehen. Die Dotierungskonzentration der p-Wannen beträgt etwa 5 x 10¹⁷ bis 8 x 10¹⁷ cm⁻³.

Bei dieser Variante hat im Gegensatz zum oben erwähnten üblichen Grabenkondensator, welcher durch das zweistufigen Grabenätzverfahren hergestellt wird, der untere Bereich des Grabens eine Breite bzw. einen Durchmesser W₂, welcher im wesentlichen gleich wie oder größer als die Breite bzw. der Durchmesser W1 des oberen Bereichs ist. Optionellerweise umgibt die vergrabene Platte 165 den unteren Bereich des Grabens 108. Wie gezeigt, überlappt die vergrabene Platte 165 teilweise mit dem oberen Bereich des Grabens. Die vergrabene Platte 165 dient als Kondensatorelektrode. Typischerweise ist im Graben stark dotiertes Polysilizium 161 mit einem Dotierstoff eines zweiten Leitungstyps. Beispielsweise ist das Polysilizium 161 stark dotiert mit n-Typ-Dotierstoffen (n⁺), wie z.B. As oder P. Bei einer Variante ist das Polysilizium 161 stark mit As dotiert. Die Konzentration von As beträgt etwa 10¹⁹ bis 10²⁰ cm⁻³.

Die Speicherdielektrikumschicht 164 trennt die Kondensatorelektroden. Bei dieser Variante verkleidet das Speicherdielektrikum 164 die inneren Seitenwände des Kragens 168 und die Grabenseitenwände im unteren Bereich des Grabens. Die Speicherdielektrikumschicht 164 umfaßt beispielsweise Nitrid oder Nitrid/Oxid. Oxid/Nitrid/Oxid oder eine sonstige dielektrische Schicht oder ein Stapel von dielektrischen Schichten, wie z.B. Oxid, nitrides Oxid oder NONO, sind ebenfalls verwendbar.

Die Verbindung der vergrabenen Platte 165 des Kondensators mit anderen Kondensatoren innerhalb der DRAM-Matrix wird über die vergrabene Wanne 170 bewerkstelligt, welche Dotierstoffe des zweiten Leitungstyps aufweist. Bei der vorliegenden Variante ist die vergrabene Wanne 170 durch Implantation von n-Typ-Dotierstoffen, wie z.B. As oder P, gebildet. Die Konzentration der vergrabenen Wanne 170 beträgt etwa 1x10¹⁷ - 1x10²⁰ cm⁻³. Die vergrabene Wanne 170 kann ebenfalls aus einer n-Typ-Epitaxieschicht gebildet werden und mit einer Referenzspannung verbunden werden. Durch Verbinden der vergrabenen Platten 165 der Kondensatoren in der DRAM-Matrix mit einer gemeinsamen Referenzspannung wird das maximale elektrische Feld in der dielektrischen Schicht 164 minimiert, was die Zuverlässigkeit verbessert. Bei dieser Variante liegt die Referenzspannung in der Mitte zwischen der L-Spannung der Bitleitung und der H-Spannung der Bitleitung, was üblicherweise der Hälfte der Versorgungsspannung oder V_{DD}/2 entspricht. Andere Referenzspannungen, wie z.B. Massepotential, sind ebenfalls verwendbar.

Die Brücke 162 ist oberhalb des dotierten Polysiliziums 161 vorgesehen. Die Dotierstoffe von dem dotierten Polysilizium 161 diffundieren in das Silizium aus, um den Kondensatoranschlußdiffusionsbereich 125 oder den Kondensatoranschluß zu bilden, welcher den Transistor 110 mit dem Kondensator 160 verbindet.

Der Kragen 168 ist im oberen Bereich des Grabens 108 gebildet und verläuft bis zur Oberseite der vergrabenen Platte 165. Wie gezeigt, ist der Kragen 168 leicht unter das Substrat 101 zurückgezogen, um die vergrabene Brücke 162 aufzunehmen. Der Kragen 168 ist aus einem dielektrischen Material hergestellt. Bei der vorliegenden Variante wird zunächst eine thermische Oxidschicht gebildet und darauf eine TEOS-Schicht abgeschieden. Der Kragen 168 verhindert oder reduziert den Leckstrom von dem Kondensatoranschluß 162 zur vergrabenen Platte 165. Bei einer Variante ist der Kragen etwa 1,2 µm tief und 20 bis 90 nm dick.

Der STI-Graben 180 ist im oberen Abschnitt des Grabens 108 zur Isolierung der DRAM-Zelle von anderen Zellen in der Matrix und zum Verhindern einer Brückenbildung zwischen benachbarten Kondensatoren vorgesehen. Wie gezeigt, überlappt der STI-Graben 180 einen Bereich des Grabens 108 und läßt einen übrigen Bereich offen, so daß ein Stromfluß zwischen dem Transistor 110 und zwischen dem Kondensator 160 möglich ist. Bei der vorliegenden Variante überlappt der STI-Graben 180 nominell etwa die Hälfte der Grabenbreite. Der STI-Graben verhindert oder reduziert den Leckstrom von Brücke zu Brücke. Die Tiefe des STI-Grabens beträgt etwa 0,25 µm.

Die vergrabene Brücke 162 weist im übrigen bei dieser Variante eine mit 200 bezeichnete Grenzfläche Polysilizium-Füllung/ vergrabene Brücke sowie eine mit 201 bezeichnete Grenzfläche vergrabene Brücke/ Substrat auf, worauf bei einer später beschriebenen Variante nochmals detaillierter eingegangen wird.

Der Transistor 110 umfaßt den Gate-Stapel 112 und die Drain/Source-Diffusionsbereiche 113 und 114. Die Diffusionsbereiche 113, 114 weisen n-Typ-Dotierstoffe, wie z.B. As oder P auf. Der Diffusionsbereich 114 ist mit der Kondensatoranschluß 125 verbunden. Der Gate-Stapel 112, welcher an die Wortleitung 120 angeschlossen ist, umfaßt eine Polysiliziumschicht. Typischerweise ist das Polysilizium mit n- oder p-Typ-Dotierstoffen dotiert. Optionellerweise ist eine Metallsilizidschicht (nicht gezeigt) über der Polysiliziumschicht gebildet, um den Schichtwiderstand des Gate-Stapels 112 zu reduzieren. Das Polysilizium und das Silizid werden oft als "Polycid(e)" bezeichnet.

Der Gate-Stapel 112 wird mit einer Nitridschicht bedeckt, welche als Ätzmaske zum Isolieren der Wortleitung verwendet wird. Zusätzlicherweise werden ein Seitenwandoxid (nicht gezeigt) und eine Verkleidung verwendet, um die Wortleitung 120 zu isolieren. Die Verkleidung umfaßt beispielsweise Nitrid oder ein anderes geeignetes Material. Die Verkleidung dient ebenfalls als Ätzstopp während der Bildung des randlosen Kontaktes 183. Der randlose Kontakt liefert eine Verbindung zwischen dem Diffusionsbereich 113 und der Bitleitung 185. Die dielektrische Schicht 189, welche beispielsweise aus BPSG oder einem anderen dielektrischen Material, wie z.B. einem Oxid besteht, isoliert die Bitleitung 185 von den Diffusionsbereichen 113, 114.

Die vorbeilaufende Wortleitung 120' ist oberhalb des STI-Grabens 180 gebildet. Die vorbeilaufende Wortleitung 120' ist von dem Graben 108 durch den STI-Graben 180 und ein dickes Deckoxid isoliert. Bei der vorliegenden Variante sind die Ränder der vorbeilaufenden Wortleitung im wesentlichen mit den Grabenseitenwänden ausgerichtet. Solche Konfiguration wird als gefaltete Bitleitungsarchitektur bezeichnet. Andere Konfigurationen, wie z.B. eine offene oder eine offene/gefaltete Struktur, sind ebenfalls anwendbar.

Wie beschrieben, ist der erste Leitungstyp der p-Typ und der zweite Leitungstyp der n-Typ. Die Erfindung ist ebenfalls auf Grabenkondensatoren anwendbar, welche p-Typ-Polysilizium in einem n-Typ-Substrat gebildet haben. Weiterhin ist es möglich, daß Substrat, die Wannen, die vergrabene Platte und die anderen Elemente der DRAM-Speicherzelle mit Verunreinigungsatomen stark oder leicht zu dotieren, um die jeweils gewünschten elektrischen Charakteristika zu erhalten.

Obwohl der erste elektrische Leitungstyp der p-Typ und der zweite elektrische Leitungstyp der n-Typ ist, ist die Bildung der DRAM-Speicherzelle in einem n-Typ-Substrat mit einem Graben, der mit p-Typ-Polysilizium gefüllt ist, ebenfalls möglich. Weiterhin ist es möglich, einen vertikalen Transistor oder andere Typen von Speicherzellen-Layouts zu verwenden.

Fig. 7a-g zeigen eine Variante des Verfahrens zur Herstellung der DRAM-Speicherzelle nach Fig. 6.

Mit Bezug auf Fig. 7a wird das Substrat 101 bereitgestellt, auf dem die DRAM-Speicherzelle herzustellen ist. Die Hauptoberfläche des Substrats 101 ist nicht kritisch, und eine beliebige geeignete Orientierung, wie z.B. (100), (110) oder (111), ist verwendbar. Bei der vorliegenden Variante ist das Substrat 101 leicht dotiert mit p-Typ-Dotierstoffen (p⁻), wie z.B. B. Die Konzentration des B beträgt etwa 1 - 2 x 10¹⁶ cm ⁻³.

Das Substrat 101 enthält die n-dotierte vergrabene Wanne 170. Die vergrabene Wanne 170 weist P oder As als Dotierstoff auf. Bei der vorliegenden Variante wird eine Maske strukturiert, um die vergrabenen Wannenbereiche zu definieren. n-Typ-Dotierstoffe werden dann in die vergrabenen Wannenbereiche des Substrats 101 implantiert. Die vergrabene Wanne 170 dient zur Isolation der p-Wanne vom Substrat 101 und bildet ebenfalls eine leitende Brücke zwischen den vergrabenen Platten 165 der Kondensatoren. Die Konzentration und Energie der Implantation betragen etwa > 1 x 10¹³ cm ⁻² bei etwa 1,5 MeV. Alternativermaßen wird die vergrabene Wanne 170 durch Implantieren und darauffolgendes Aufwachsenlassen einer Epitaxie-Siliziumschicht oberhalb der Substratoberfläche gebildet. Diese Technik ist beschrieben im US-Patent Nr. 5,250,829 von Bronner et al.

Der Unterbaustapel 107 wird auf der Oberfläche des Substrats 101 gebildet. Der Unterbaustapel 107 umfaßt beispielsweise die Unterbau-Oxidschicht 104 und die Unterbau-Stoppschicht 105. Die Unterbau-Stoppschicht 105, welche als Politur oder Ätzstopp für folgende Prozesse gilt, weist beispielsweise Nitrid auf. Oberhalb der Unterbau-Stoppschicht 105 ist die Hartmaskenschicht 106 vorgesehen. Diese Hartmaskenschicht 106 umfaßt TEOS. Andere Materialien, wie z.B. BSG, sind ebenfalls als Hartmaskenschicht verwendbar.

Zusätzlicherweise kann eine Antireflexionsbeschichtung (ARC) verwendet werden, um die lithographische Auflösung zu verbessern.

Die Hartmaskenschicht 106 wird unter Verwendung üblicher photolithographischer Techniken strukturiert, um den Bereich 102 zu definieren, in dem der Graben zu bilden ist. Diese Schritte enthalten die Abscheidung einer Photolackschicht und das selektive Belichten derselben mit dem erwünschten Muster. Der Photolack wird dann entwickelt und entweder die belichteten oder die unbelichteten Bereiche werden entfernt, und zwar abhängig davon, ob ein Positivlack oder ein Negativlack verwendet wird. Die belichteten Bereiche des Unterbaustapels 107 werden dann bis zur Oberfläche des Substrats 101 geätzt. Ein reaktiver Ionenätzschritt (RIE) bildet dann den tiefen Graben 108.

Eine Polysilizium-Halbleiterschicht 152 wird dann über dem Wafer abgeschieden, um den Graben 108 zu füllen. Amorphes Silizium ist ebenfalls verwendbar. Weitere Materialtypen, welche eine Temperaturstabilität bis zu 1050 bis 1100°C aufweisen und selektiv gegenüber Nitrid oder Oxid entfernbar sind, sind ebenfalls verwendbar. Das Polysilizium 152 wird als Polysilizium-Opferschicht bezeichnet, da es später entfernt wird. Typischerweise wird ein natürliches Oxid 151 gebildet, welches die Grabenseitenwände auskleidet, bevor der Graben mit dem Polysilizium 152 gefüllt wird. Die Oxidschicht 151 ist typischerweise etwa 0,3-5 nm dick.

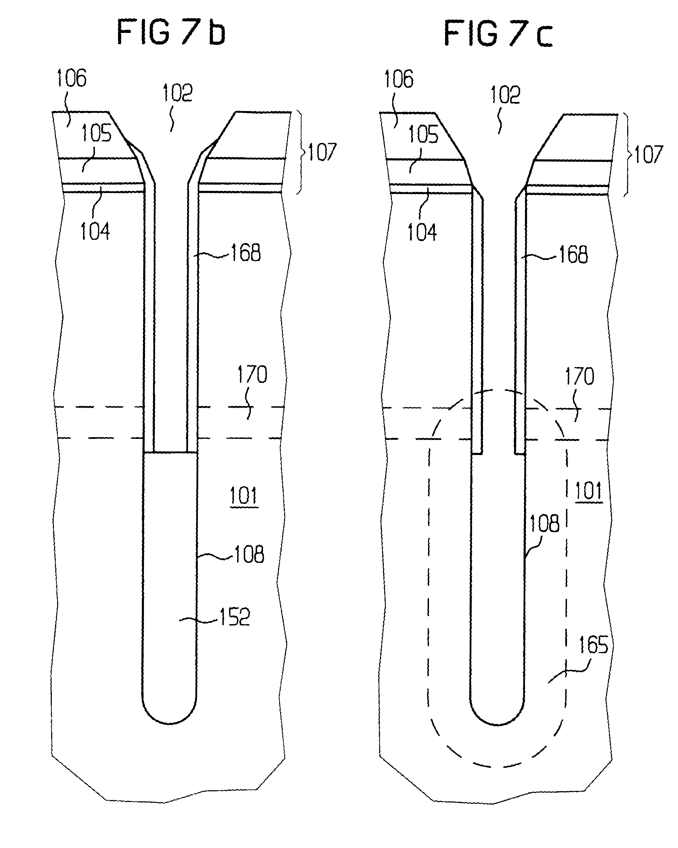

Wie in Fig. 7b gezeugt, wird das Polysilizium 152 dann bis zur Unterseite des zu bildenden Kragens entfernt. Das Entfernen des Polysiliziums 152 beinhaltet beispielsweise das Planarisieren mittels chemisch-mechanischen Polierens, ein chemisches Trockenätzen (CDE) oder ein reaktives Ionenätzen zum Bilden einer koplanaren Oberfläche mit der Oberseite des Polysiliziums in dem Graben 108 und an der Oberseite des Unterbaustapels 107. Ein reaktives Ionenätzen wird dann durchgeführt, um das Polysilizium 152 in dem Graben 108 einzusenken. Die Verwendung einer chemischen Trockenätzung zum Absenken des Polysiliziums 152 im Graben 108 ist ebenfalls möglich. Vorzugsweise jedoch wird das Polysilizium 152 planarisiert und durch ein CDE oder RIE in einem einzelnen Schritt eingesenkt, typischerweise um 0,5 - 2 µm von der Substratoberfläche.

Eine dielektrische Schicht wird dann über dem Wafer abgeschieden, welche den Unterbaustapel 107 und die Grabenseitenwände bedeckt. Die dielektrische Schicht wird zur Bildung des Kragens 168 verwendet. Die dielektrische Schicht ist beispielsweise aus Oxid. Bei der vorliegenden Variante wird die dielektrische Schicht durch Aufwachsen einer Schicht aus thermischem Oxid und darauffolgendes Abscheiden einer Oxidschicht durch chemische Dampfphasenabscheidung (CVD), wie z.B. plasmaunterstützte CVD (PECVD) oder Niederdruck-CVD (LPCVD), unter Verwendung von TEOS gebildet. Das CVD-Oxid kann durch einen Temperschritt verdichtet werden. Die Oxidschicht ist hinreichend dick, um einen vertikalen Leckstrom zu vermeiden, nämlich 10-50 nm. Alternativermaßen kann die dielektrische Schicht eine Schicht aus thermischem Oxid aufweisen.

Bei einer anderen Variante wird die dielektrische Schicht aus CVD-Oxid gebildet. Nach der Bildung des CVD-Oxids kann ein Temperschritt zur Verdichtung des Oxids durchgeführt werden. Der Temperschritt wird beispielsweise in Ar, N2, O₂, H₂O, N₂O, NO oder NH₃-Atmosphäre durchgeführt. Eine oxidierende Atmosphäre, wie z.B. O₂ oder H₂O kann zur Bildung einer thermischen Oxidschicht unter dem CVD-Oxid verwendet werden. Sauerstoff aus der Atmosphäre diffundiert dann durch das CVD-Oxid zum Bilden einer thermischen Oxidschicht auf der Substratoberfläche. Dies ermöglicht vorteilhafterweise die Bildung eines thermischen Oxids, falls erwünscht, ohne das Bedürfnis eines thermischen Oxidationsschritts vor der Abscheidung des CVD-Oxids. Typischerweise wird der Temperschritt bei einer Temperatur von etwa 1000-1100°C und etwa 0,5-3 Stunden lang durchgeführt.

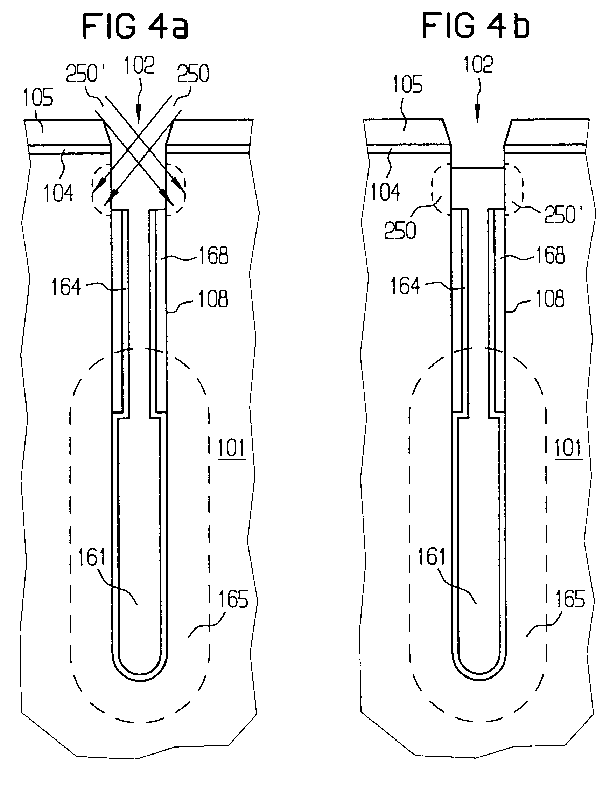

Weiter mit Bezug auf Fig. 7b wird die dielektrische Schicht beispielsweise durch reaktives Ionenätzen geätzt, um den Kragen 168 zu bilden. Die chemischen Mittel für das reaktive Ionenätzen werden derart gewählt, daß das Oxid selektiv gegenüber dem Polysilizium 152 und dem Nitrid 106 geätzt wird. Das reaktive Ionenätzen entfernt die dielektrische Schicht von der Oberfläche des Unterbaustapels und dem Boden der Öffnung. Die dielektrische Schicht bleibt auf der Siliziumseitenwand, um den Kragen 168 zu bilden. Wie in Fig. 4b abgebildet, ist der obere Bereich des Kragens 168 leicht erodiert und bildet einen abgeschrägten oberen Abschnitt.

Mit Bezug auf Fig. 7c wird die Polysilizium-Opferschicht 152 von der Unterseite des Grabens 108 entfernt. Das Entfernen der Polysilizium-Opferschicht 152 wird vorzugsweise durch CDE erreicht. Die dünne natürliche Oxidschicht 151 liegt dann typischerweise auf den freigelegten Grabenseitenwänden vor. Diese dünne natürliche Oxidschicht 151 kann ausreichen, um als CDE-Ätzstopp zu dienen. Ein CDE-Ätzschritt, beispielsweise unter Verwendung von NF₃ + Cl₂ als Chemikalien kann Silizium oder Polysilizium mit relativ hoher Selektivität gegenüber Oxid ätzen, was eine Entfernung des Polysiliziums unter Verwendung der dünnen natürlichen Oxidschicht 151 als Ätzstopp ermöglicht. Beispielsweise wurde eine Selektivität von etwa 4000:1 für das Entfernen des Polysiliziums von dem Graben 108 unter Verwendung des natürlichen Oxids 151 als Ätzstoppschicht ermittelt.

Bei einer anderen Variante wird ein CDE-Schritt mit hohem C12-Gehalt verwendet, um die Selektivität der Silizium- bzw. Polysiliziumätzung gegenüber dem Oxid zu erhöhen. Eine Strömungsrate von etwa 12 sccm resultiert in einer effektiven Oxidätzrate von null, während die Polysilizium-Ätzrate in der Größenordnung von etwa 2 µm/min liegt. Dies ermöglicht, daß die natürliche Oxidschicht 151 als effizienter Ätzstopp für die Entfernung der Opfer-Polysiliziumschicht dient. Typischerweise beträgt die Dicke des natürlichen Oxids 151 etwa 0,5 bis 1 nm.

Alternativermaßen kann eine Naßätzung, beispielsweise unter Verwendung von KOH oder HF:HNO₃:CH₃COOH ebenfalls beim Entfernen des Polysiliziums verwendet werden. Die Verwendung von KOH jedoch kann zu einer K-Kontamination auf der Grabenseitenwand führen, was einen zusätzlichen Reinigungsschritt erfordern kann. Eine reaktive Ionenätzung ist ebenfalls möglich beim Entfernen des Polysiliziums, da sie anisotrop wirkt. Geeignete Chemikalien für die reaktive Ionenätzung für die Beseitigung des Polysiliziums enthalten SF₆/NF₃/HBr. Andere geeignete Chemikalien, welche Polysilizium selektiv gegenüber Oxid oder Nitrid ätzen, sind beispielsweise NF₃/HBr oder CF₄/O₂ oder CF₄/O₂/Cl₂.

Die Selektivität der reaktiven Ionenätzung hinsichtlich Poly gegenüber Oxid oder Nitrid beträgt etwa weniger als 100:1 auf planaren Oberflächen, aber steigt auf mehr als etwa 2000:1 auf vertikalen Oberflächen, und zwar aufgrund der vorzugsweise vertikalen Richtung der Bewegung der Ionen während der reaktiven Ionenätzung. Aufgrund der hohen Selektivität des Polysiliziums gegenüber Oxid oder Nitrid auf den vertikalen Oberflächen wird nur der obere Bereich des Kragens 168 erodiert. Jedoch ist dies kein Problem, da der Kragen 168 nicht unterhalb der Oberfläche des Substrats erodiert wird.

Nach Entfernung des Polysiliziums wird die vergrabene Platte 165 mit n-Typ-Dotierstoffen, wie z.B. As oder P, optionell als die zweite Kondensatorelektrode gebildet. Der Kragen 168 dient als Isolationsmaske, die ermöglicht, daß nur der Bereich unterhalb des Kragens 168 dotiert wird. Die Konzentration der Dotierstoffe beträgt etwa 1 x 10¹⁹ - 10²⁰ cm⁻³. Zur Bildung der vergrabenen Platte 165 kann eine Gasphasendotierung unter Verwendung von PH3 oder AsH3, eine Plasmadotierung oder eine Plasmaimmersions-Ionenimplantation (PIII) verwendet werden. Solche Techniken sind beispielsweise beschrieben in Ransom et al., J. Electrochemical. Soc. Band 141, Nr. 5 (1994), S. 1378 ff.; US-Patent Nr. 5,344,381 und US-Patent Nr. 4,937,205.

Eine Ionenimplantation unter Verwendung des Kragens 168 als Isolationsmaske ist ebenfalls möglich. Alternativermaßen kann die vergrabene Platte 165 unter Verwendung eines dotierten Silikatglases, wie z.B. ASG, als Dotierstoffquelle gebildet werden. Die Verwendung von dotiertem Silikatglas als Dotierstoffquelle ist beispielsweise beschrieben in Becker et al., J. Electrochemical. Soc., Band 136 (1989), S. 3033 ff. Wenn dotiertes Silikatglas verwendet wird, wird die Schicht nach der Bildung der vergrabenen Platte entfernt.

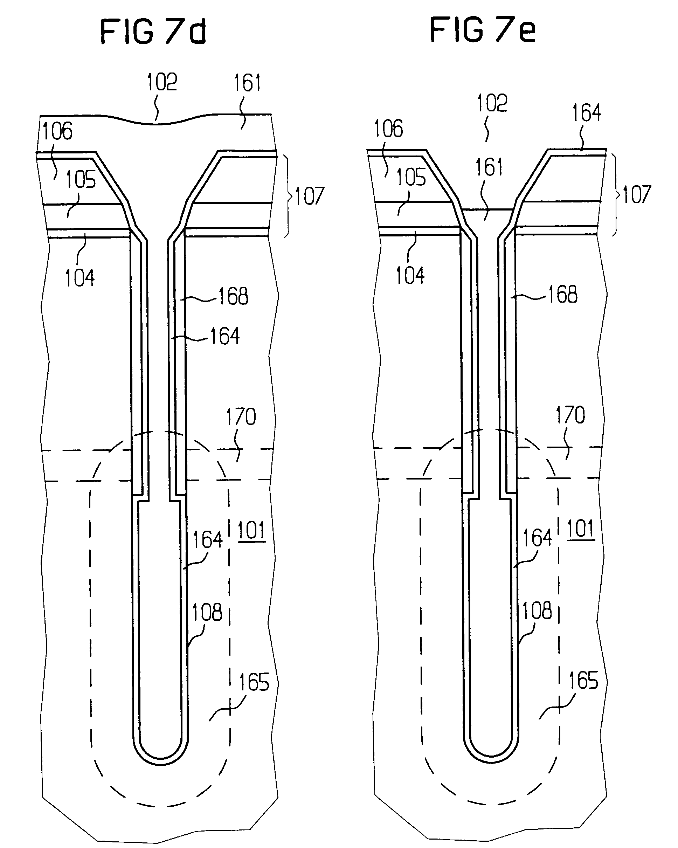

Mit Bezug auf Fig. 7d wird eine Speicherdielektrikumschicht 164 auf dem Wafer abgeschieden, welche die Oberfläche des Unterbaustapels 107 und das Innere des Grabens 108 bedeckt. Die Speicherdielektrikumschicht 164 dient als Speicherdielektrikum zum Separieren der Kondensatorplatten. Bei einer Variante umfaßt die dielektrische Schicht einen NO-Film-Stapel. Der NO-Film-Stapel wird durch Abscheiden einer Nitridschicht gebildet, welche dann reoxidiert wird. Die Nitridschicht wird beispielsweise durch thermische Nitrierung und CVD-Nitrid mit einer Dicke von etwa 5 nm ausgebildet.

Die Nitridschicht wird beispielsweise bei einer Temperatur von etwa 900°C reoxidiert. Die Reoxidation der Nitridschicht erhöht die Dicke der Nitridschicht marginal. Weitere Typen von dielektrischen Filmstapeln, wie z.B. Oxid-Nitrid-Oxid (ONO) oder Oxid-Nitrid-Oxid-Nitrid (ONON), sind ebenfalls nützlich. Ebenfalls ist die Verwendung eines dünnen Oxids, Nitrids oder nitrierten Oxidfilms möglich.

Eine weitere Polysiliziumschicht 161 wird auf der Oberfläche des Wafers zum Füllen des Grabens 108 und zum Bedecken des Unterbaustapels 107 abgeschieden, und zwar beispielsweise durch CVD oder andere bekannte Techniken. Wie gezeigt, ist die Polysiliziumschicht 161 konform und dotiert mit n-Typ-Dotierstoffen, wie z.B. P und As. Bei einer Variante ist die Polysiliziumschicht 161 mit As dotiert. Die Konzentration von As beträgt etwa 1 x 10¹⁹ - 1 x 10²⁰ cm⁻³. Das dotierte Polysilizium 161 dient als Kondensatorelektrode. Alternativermaßen kann die Schicht aus amorphem Silizium bestehen. Dieses Material kann entweder in situ oder sequentiell dotiert werden.

Mit Bezug auf Fig. 7e wird die Polysiliziumschicht 161 beispielsweise durch einen CDE-Schritt oder durch einen RIE-Schritt unter Verwendung geeigneter Chemikalien, wie z.B. NF₃/Cl₂ oder NF₃/HBr oder SF₆ abgesenkt. Bei einer anderen Variante wird das Polysilizium 161 auf etwa den Pegel des Unterbau-Nitrids 106 abgesenkt. Dies schützt vorteilhafterweise das Unterbauoxid 105 während der folgenden Naßätzprozesse. Falls die Unterätzung kein Problem darstellt, kann das Polysilizium bis zur Tiefe der vergrabenen Brücke eingesenkt werden.

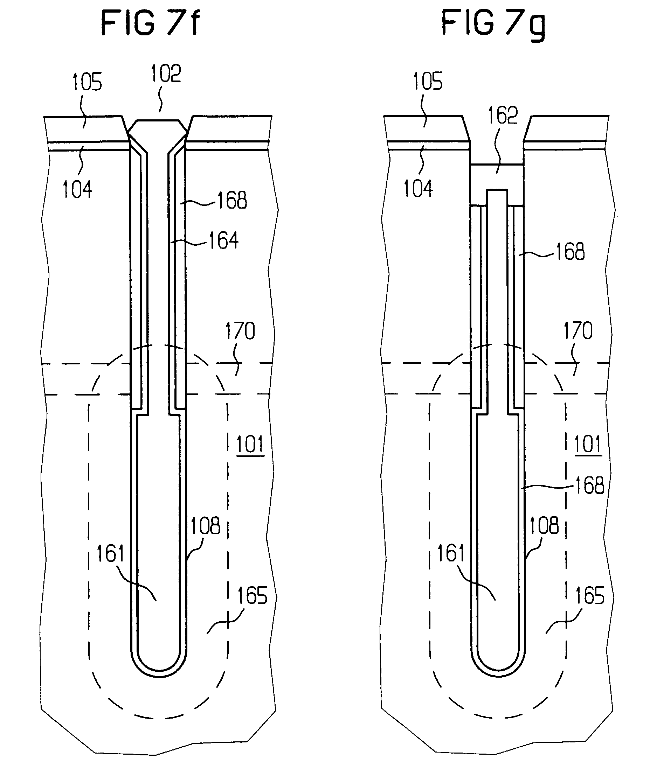

Gemäß Fig. 7f wird die restliche Speicherdielektrikumsschicht 164 oberhalb des Polysiliziums 161 mit einer Naßätzung entfernt, und zwar beispielsweise mit DHF und HF/ Glyzerol. Die Hartmaskenschicht 106 wird dann ebenfalls naßchemisch entfernt, und zwar mit BHF. Auch ist die Durchführung eines CDE-Schrittes dazu möglich. Die Hartmaskenschicht kann auch füher im Prozeßablauf entfernt werden, wie z.B. nach der Bildung des tiefen Grabens 108. Wie gezeigt, sind der Kragen 168 und die dielektrische Schicht 164 im Graben 108 ebenfalls leicht eingesenkt.

Wie in Fig. 7g gezeigt, wird dann die vergrabene Brücke 162 gebildet. Die Bildung der vergrabenen Brücke 162 wird beispielsweise durch eine Ätzung zum Einsenken des dotierten Polysiliziums 161 in dem Graben erreicht. Typischerweise wird hierzu eine reaktive Ionenätzung verwendet. Der nicht-aktive Bereich der Zelle wird dann durch eine übliche fotolithographische Technik definiert und dann anisotrop geätzt, und zwar zweckmäßigerweise durch reaktives Ionenätzen. Der nicht-aktive Bereich ist der Bereich, in dem der STI-Graben 180 zu bilden ist.

Wie mit erneutem Bezug auf Fig. 6 gezeigt, überlappt der STI-Graben 180 einen Teil des Grabens, um so einen Teil der Brücke 162 abzuschneiden. In einem folgenden Temperschritt diffundieren Dotierstoffe von dem dotierten Polysilizium 161 nach oben und nach außen durch die Brücke 162 zum Bilden des Diffusionsbereichs 125. Die Tiefe des STI-Grabens beträgt etwa 0,25 µm. Typischerweise wird der nicht-aktive Bereich unterhalb der Oberseite des Oxids des Kragens 168 geätzt. Bei einer Variante wird der nicht-aktive Bereich etwa 0,25 µm unterhalb der Substratoberfläche geätzt.

Nachdem der nicht-aktive Bereich geätzt ist, werden die Fotolack- und ARC-Schichten entfernt. Um zu gewährleisten, daß keine Fotolack- oder ARC-Rückstände zurückbleiben, können Reinigungsschritte verwendet werden. Um zu verhindern, daß Sauerstoff in die Silizium- und Polysiliziumseitenwände diffundiert, ist eine (nicht gezeigte) optionale Verkleidung vorgesehen, um den nicht-aktiven Bereich zu schützen. Die Verkleidung umfaßt beispielsweise Nitrid. Typischerweise wird ein Passivierungsoxid thermisch auf dem freiliegenden Silizium vor der Bildung der Nitridauskleidung aufgewachsen. Die Nitridauskleidung wird beispielsweise durch chemische Niederdruck-Dampfabscheidung (LPCVD) gebildet.

Ein dielektrisches Material wird auf der Oberfläche des Substrats gebildet. Das dielektrische Material weist beispielsweise SiO₂ auf. Bei einer weiteren Variante ist das dielektrische Material TEOS. Ein Hochdichteplasma-(HDP-)Oxid oder ein anderes Isolationsmaterial kann verwendet werden. Die Dicke der dielektrischen Schicht reicht aus zum Füllen des nicht-aktiven Bereichs. Da die dielektrische Schicht typischerweise konform ist, werden Planarisierungsverfahren, wie z.B. chemisch-mechanisches Polieren, angewendet. Solche Verfahren sind beispielsweise beschrieben in Nesbit et al., A 0,6 µm² 256Mb Trench DRAM Cell With Self-Aligned Buried Strap (BEST), IEDM 93-627. Die Oberfläche des Substrats 101 wird dann derart poliert, daß die STI-Gräben 180 und die Nitridschicht im wesentlichen planar sind.

Die Unterbau-Stoppschicht 105 wird dann beispielsweise durch eine naßchemische Ätzung entfernt. Die naßchemische Ätzung ist selektiv gegenüber Oxid. Das Unterbauoxid 104 wird ebenfalls an diesem Punkt durch eine naßchemische Ätzung entfernt, welche selektiv gegenüber Silizium ist. Nach Entfernung des Unterbauoxids 104 wird eine Oxidschicht auf der Oberfläche des Wafers gebildet. Diese Oxidschicht, welche als Gate-Opferschicht bezeichnet wird, dient als Streuoxid für folgende Implantationen.

Zur Definition eines Bereichs für eine p-Typ-Wanne für den n-Kanal-Transistor 110 der DRAM-Speicherzelle wird eine Fotolackschicht auf der Oberseite der Oxidschicht abgeschieden und geeignet strukturiert, um den p-Wannenbereich freizulegen. Wie gezeigt, werden p-Typ-Dotierstoffe, wie z.B. Bor (B) in den Wannenbereich implantiert. Die Dotierstoffe werden hinreichend tief implantiert, um einen Punchthrough zu verhindern und den Schichtwiderstand zu reduzieren. Das Dotierstoffprofil ist derart bemessen, daß die erwünschten elektrischen Charakteristika erhalten werden, z.B. eine erwünschte Gate-Schwellspannung (Vₜₕ).

Zusätzlicherweise werden ebenfalls p-Typ-Wannen für die n-Kanal-Versorgungsschaltungsanordnung gebildet. Für komplementäre Wannen in komplementären Metalloxid-Siliziumvorrichtungen (CMOS) werden n-Wannen gebildet. Die Bildung von n-Typ-Wannen erfordert zusätzlich fotolithographische Schritte und Implantationsschritte zum Definieren und Bilden der n-Typ-Wannen. Wie bei den p-Typ-Wannen sind die Profile der n-Typ-Wannen auf das Erreichen der erwünschten elektrischen Charakteristika zugeschnitten. Nach Bildung der Wannen wird die Gate-Opferschicht entfernt.

Die verschiedenen Schichten zum Bilden des Gates 112 des Transistors 110 werden dann hergestellt. Dies umfaßt das Bilden einer Gate-Oxidationsschicht, welche als Gate-Oxid dient, einer Polysiliziumschicht und einer Decknitridschicht. Typischerweise kann die Polysiliziumschicht eine Metallsilizidschicht, wie z.B. WSiₓ, enthalten, wobei das gebildete Polycide den Schichtwiderstand reduziert. Die verschiedenen Gate-Schichten werden dann strukturiert, um den Gate-Stapel 112 des Transistors 110 zu bilden. Die Seitenwand des Gatestapels wird dann z.B. durch thermische Oxidation isoliert.

Ein vorbeilaufender Gate-Stapel als Wortleitung 120' wird typischerweise über dem Graben gebildet und ist davon durch den STI-Graben 180 isoliert. Die Source/Drain-Diffusionsbereiche 413 und 414 werden durch Implantieren von n-Typ-Dotierstoffen, wie z.B. P oder As gebildet. Bei einer Variante wird P in die Source- und Drain-Bereiche 113, 114 implantiert. Die Dosis und die Energie werden derart ausgewählt, daß ein Dotierstoffprofil erzielt wird, welches die erwünschten Betriebscharakteristika gewährleistet. Zur Verbesserung der Diffusion und der Ausrichtung der Source und des Drain mit dem Gate können Nitridabstandshalter (nicht gezeigt) verwendet werden. Der Diffusionsbereich 114 ist mit dem Diffusionsbereich 125 verbunden, um so den Kondensatoranschluß zu bilden.

Die dielektrische Schicht 189 wird über der Waferoberfläche gebildet, und sie überdeckt die Gates 112 und die Substratoberfläche. Die dielektrische Schicht umfaßt beispielsweise BPSG. Weitere dielektrische Schichten, wie z.B. TEOS, sind ebenfalls nützlich. Wie gezeigt, wird eine randlose Kontaktöffnung 483 geätzt, um den Diffusionsbereich 413 zu freizulegen. Die Kontaktöffnung wird dann mit einem leitenden Material, wie z.B. n⁺-dotierten Polysilizium gefüllt, um darin einen Kontaktstöpsel zu bilden. Die Metallschicht 485, welche eine Bitleitung darstellt, wird über der dielektrischen Schicht gebildet, um einen Kontakt mit der Source über den Kontaktstöpsel zu bilden. So erhält man schließlich die in Fig. 6 gezeigte Struktur.

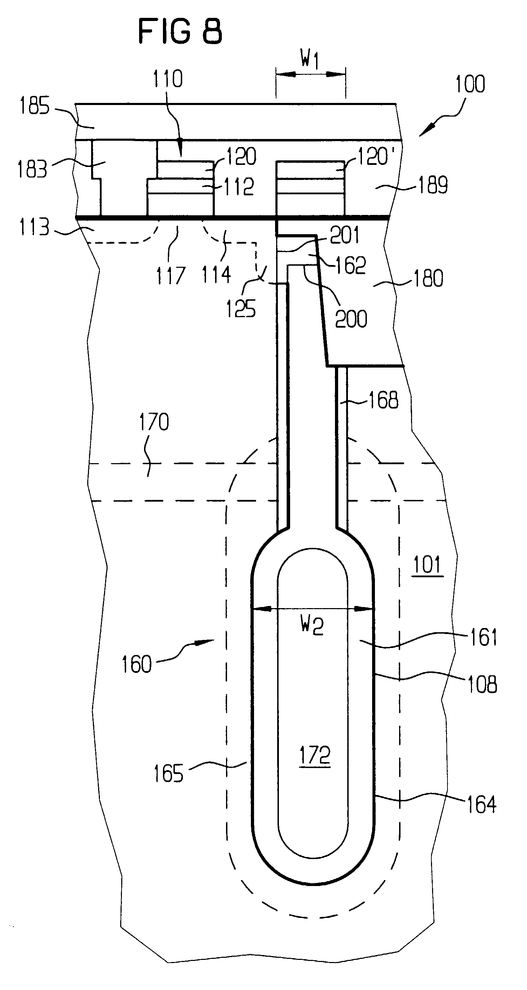

Fig. 8 zeigt ein weiteres beispiel einer üblichen DRAM-Zelle entsprechend einer weiteren Verfahrensvariante.

Wie dort gezeigt, ist die Breite W₂ bzw. der Durchmesser des unteren Bereichs des Grabenkondensators 160 größer als die Breite W₁ bzw. der Durchmesser des oberen Bereichs. Die Erhöhung von W₁ erhöht die Kapazität des Kondensators. Zum Erzielen solch einer Struktur wird die in Fig. 7b beschriebene Polysilizium-Opferschicht 152 durch CDE beseitigt, beispielsweise mit NF₃/Cl₂. Weitere Chemikalien zum selektiven Ätzen von Silizium sind ebenfalls verwendbar. Zusätzlich ist eine reaktive Ionenätzung unter Verwendung von SF₆, NF₃/HBr oder eine Naßätzung unter Verwendung von KOH anwendbar. Der untere Teil des Grabens wird beispielsweise durch eine CDE-Ätzung aufgeweitet. Die Aufweitung des Grabens ist beispielsweise beschrieben in T. Ozaki et al., 0,228 µm² Trench Cell Technologies with Bottle-shaped Capacitor for 1 Gigabit DRAMs, IEDM 95, pp. 661 oder US-Patent Nr. 5,336,912 von S. Ohtsuki. Das Ätzmittel für die CDE-Ätzung ist derart ausgewählt, daß es ebenfalls des dünnen natürlichen Oxidfilm auf den Grabenseitenwänden entfernt. Dies kann durch Reduzieren der Strömungsrate von C12 erzielt werden, um die Selektivität der Ätzung gegenüber dem Oxid zu erniedrigen, oder durch Änderung der Chemikalien.

Die Naßätzung oder die CDE ist so gesteuert, daß sie das Opfer-Polysilizium entfernt, während sie die Aufweitung derart begrenzt, daß sie sich nicht in benachbarte Gräben erstreckt oder diese kontaktiert. Die Aufweitung des unteren Bereichs des Grabens beträgt etwa 50% des minimalen Abstands zwischen benachbarten Gräben, und vorzugsweise weniger als 20-30% des minimalen Abstands zwischen benachbarten Gräben. Da der Abstand zwischen benachbarten Gräben typischerweise zur minimalen Dimension ist, sollte die Aufweitung auf weniger als 50% der minimalen Dimension begrenzt sein. Dies liefert beispielsweise einen Graben mit Flaschengestalt, dessen unterer Durchmesser weniger als die doppelte minimale Dimension beträgt. Vorzugsweise beträgt die Aufweitung des Grabens etwa 20-40% der minimalen Dimension.

Nach Entfernen des Opfer-Polysiliziums und der Ätzstoppschicht kann optionellerweise die vergrabene Platte 165 gebildet werden. Verschiedene Techniken zum Bilden der vergrabenen Platte, wie z.B. Gasphasendotierung mit AsH3 oder PH3 bei Temperaturen von etwa 1000-1100°C, Ionenimplantation von As oder P, Plasmadotierung oder Plasmaimmersions-Ionenimplantation sind ebenfalls möglich. Das dotierte Polysilizium wird dann abgeschieden, um die Kondensatorelektrode zu bilden. Das dotierte Polysilizium füllt den unteren Bereich des Grabens unter Bildung eines Hohlraums 172. Da der Hohlraum 172 in dem unteren Bereich des Grabens liegt, beeinflußt er die folgende Verarbeitung oder Funktionalität der Vorrichtung nicht. Weitere Techniken zum Erhöhen der Grabenkapazität, wie z.B. die Bildung von halbkugelartigen Siliziumkörnern (HSG) in dem Graben oder das Aufrauhen der Grabenseitenwände vor der Abscheidung des Speicherdielektrikums sind ebenfalls möglich.

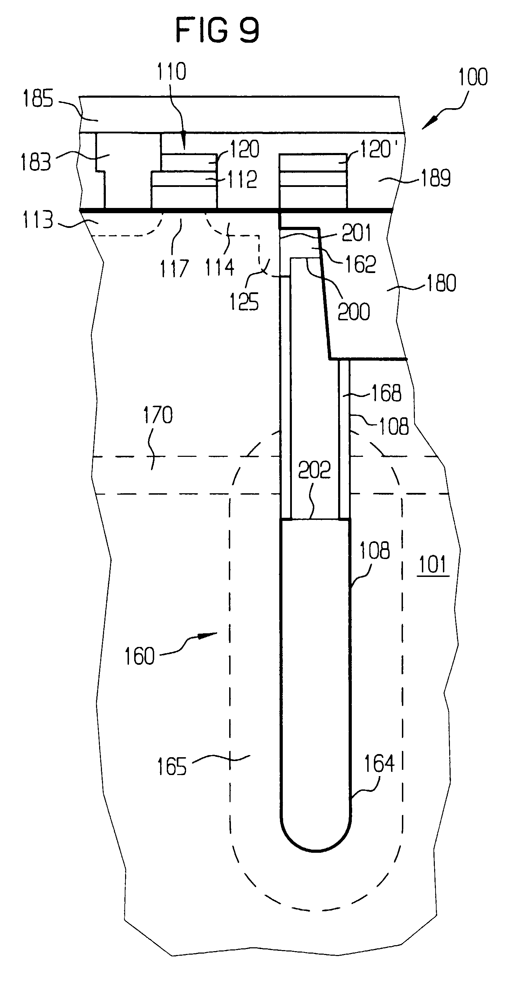

Fig. 9 zeigt eine weitere übliche DRAM-Zelle, bei welcher der Grabenkondensator 160 herstellungsgemäß eine weitere Grenzfläche 202 zwischen dem unteren Teil des Grabens 108 und dem oberen Teil des Grabens 108 aufweist, nämlich an der Unterseite des Kragens 168. Die weitere Grenzfläche 202 rührt dabei von einem zweistufigen Polysilizium-Füllprozeß her, bei dem der Graben zuerst mit Polysilizium gefüllt wird, dann dieses zur Bildung des Kragens eingesenkt wird und dann schließlich nach Bildung des Kragens wiederaufgefüllt wird. Ein derartiges Verfahren ist beispielsweise in der US-A-5,360,758 von Bronner et al. beschrieben.

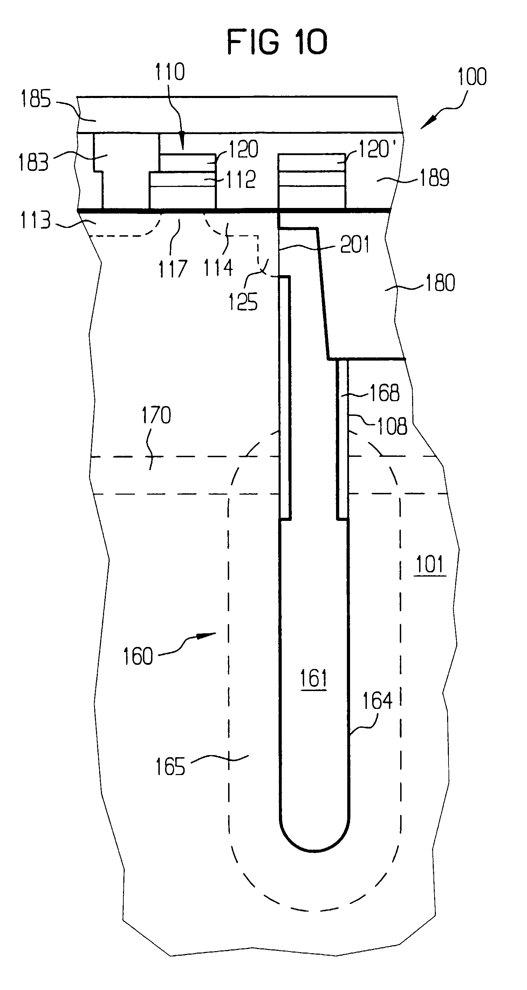

Fig. 10 zeigt eine weitere übliche DRAM-Zelle entsprechend einer weiteren Verfahrensvariante.

Wie mit Rückbezug auf Figur 6 gezeigt, gibt es bei dieser Variante der DRAM-Zelle zwei interne Grenzflächen 200, 201 für den Grabenkondensator 160, nämlich eine erste zwischen der Polysilizium-Füllung 161 und der vergrabenen Brücke 162 sowie eine zweite zwischen der vergrabenen Brücke 162 und dem Kondensatoranschlußdiffusionsbereich 125 im Substrat 101.

Diese beiden Grenzflächen 200, 201 weisen einen erhöhten elektrischen Widerstand auf und verlangsamen somit die Geschwindigkeit in den Schreib/Lese-Zyklen der die DRAM-Zelle verwendenden Speichervorrichtung. Die Grenzfläche 200 ist typischerweise eine Polysilizium/Polysilizium-Grenzfläche, und die Grenzfläche 201 ist typischerweise eine Silizium-Einkristall/Polysilizium-Grenzfläche.

Die in Figur 10 gezeigte Variante einer DRAM-Zelle weist nur noch eine Grenzfläche 201 zwischen der Polysilizium-Füllung 161 und dem Kondensatoranschlußdiffusionsbereich 125 im Substrat 101 auf. Die vergrabene Brücke 162 ist bei dieser Variante nicht vorgesehen.

Somit weist diese Variante einen geringeren Übergangswiderstand zwischen Transistor 110 und dem Grabenkondensator 160 auf, was seine Anfälligkeit gegenüber Ausfällen beim Transfer von Ladung von und zu dem Grabenkondensator 160 bei Lese/Schreib-Zyklen reduziert bzw. eine höhere Geschwindigkeit von Lese/Schreib-Zyklen ermöglicht.

Die verbleibende Grenzfläche 201 kann ein natürliches Oxid (z.B. 0,3-0,8 nm) von einer vorhergehenden Naßvorreinigung sein, oder sie kann irgendeine geeignete aufgewachsene oder abgeschiedene Schicht, wie z.B. thermisches Oxid oder CVD-Oxid, Oxinitrid oder Nitrid, mit Dicken im Bereich von typischerweise 0,3-2 nm sein. Eine In-Situ-Vorreinigung mit H2, HF-Dampf oder ein UHV-Tempern können ebenfalls vor der Bildung der Grenzfläche 201 durchgeführt werden.

Die besondere Bedeutung des Designs der Grenzfläche 201 liegt im Vermeiden einer unkontrollierten Rekristallisierung und Defektbildung an der Grenzfläche des vergrabenen Kontakts zwischen Transistor 110 und Grabenkondensator 160. Ein wichtiger Vorteil dieser Variante liegt darin, daß es nur noch eine einzige Grenzfläche 201 für den vergrabenen Kontakt gibt, da die Grabenfüllung nach Definition des vergrabenen Kontaktbereichs durchgeführt wird. Somit ist der Widerstand für die Lese/Schreib-Zyklen viel geringer, und die Prozeßausbeute ist entsprechend besser.

Fig. lla-d zeigen eine Variante des Verfahrens zur Herstellung der DRAM-Speicherzelle nach Fig. 10.

Wie in Figur lla gezeigt, welche sich an das Prozeßstadium gemäß Figur 7c anschließt, ist die Hartmaskenschicht 106 entfernt, ist das Speicherdielektrikum 164 im Graben 108 und auf der Substratoberfläche aufgebracht und ist der Graben 108 mit einem Opfermaterial 210, hier z.B. mit einem Fotolack, gefüllt.

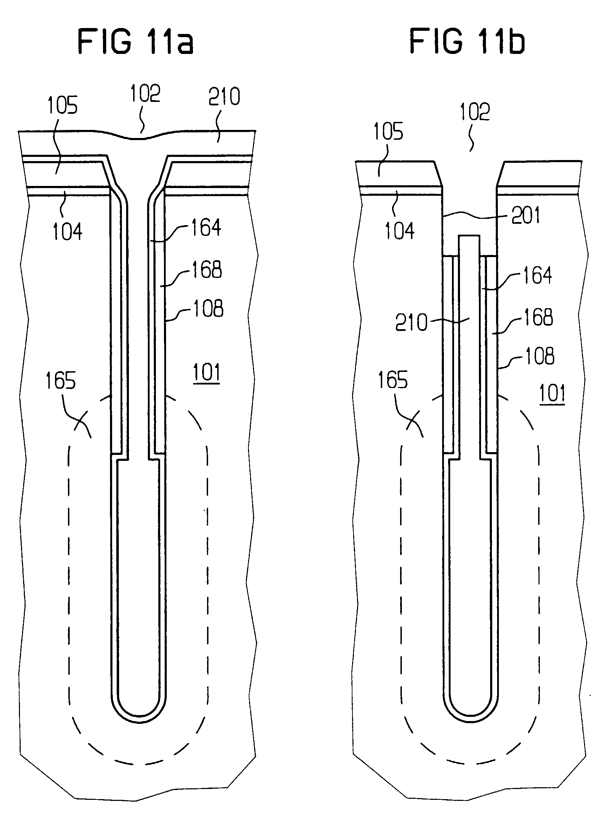

Wie in Figur 11b illustriert, wird zunächst der Opfer-Fotolack 210 mittels einer CDE-Ätzung eingesenkt, und darauffolgend wird der obere Bereich des Kragens 168 zusammen mit der darauf befindlichen Speicherdielektrikumsschicht 164 eingesenkt, um den vergrabenen Kontakt an der Grenzfläche 201 zum Substrat 101 zu definieren. Auch dies geschieht mittels einer CDE-Ätzung, welche gegenüber dem Opfer-Fotolack 210 und dem Substrat 101 gegenüber selektiv ist, oder mittels einer entsprechenden Naßätzung.

Eine Alternative zum Opferfotolack ist eine hochdotierte Polysiliziumschicht (n-dotiert) bzw. amorphe Siliziumschicht, die mittels CDE selektiv zu Oxid, Nitrid und der noch undotierten Grenzfläche 201 geätzt werden kann. Der Vorteil dabei liegt in einer besseren Steuerbarkeit des Einsenkens.

Optionellerweise kann das Speicherdielektrikum 164 nach dem Einsenken des Kragens 168 von den Seitenwänden des vorstehenden Opfer-Fotolackstöpsels 210 entfernt werden.

Wie in Figur llc gezeigt, wird anschließend der Opfer-Fotolackstöpsel 210 entfernt, nämlich beispielsweise durch eine CDE-Ätzung oder eine Naßätzung.

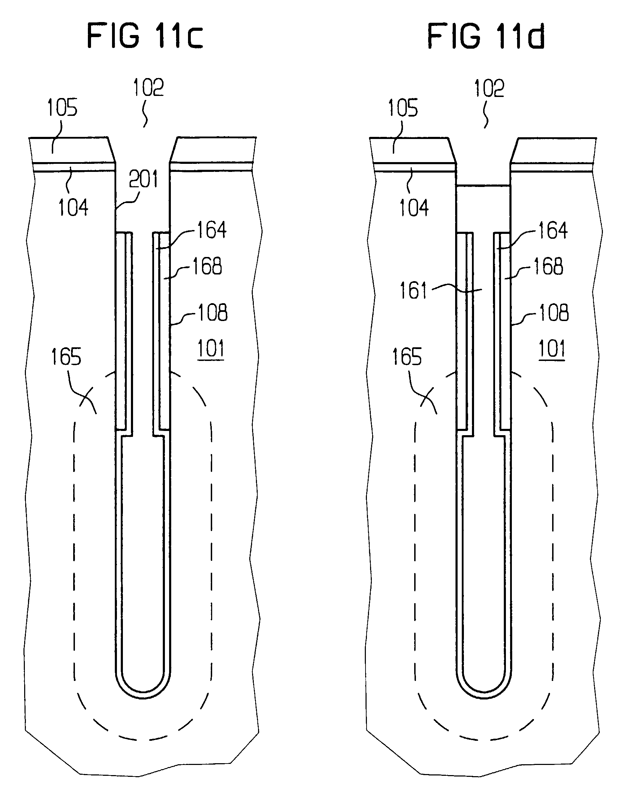

Anschließend erfolgt mit Bezug auf Figur 11d eine Vorreinigung mittels einer H₂-Temperung oder einem HF-Dampfschritt oder einem UHV-Temperschritt. Eine konventionelle naßchemische Vorreinigung (z.B. BHF o.ä.) ist ebenfalls möglich.

Optionellerweise wird ein Barrierenfilm auf der Grenzfläche 201 gebildet, beispielsweise ein dünnes Oxid oder Nitrid oder Oxinitrid, und zwar mit oder ohne der Vorreinigung vom vorherigen Schritt, nämlich in-situ, d.h. der Wafer wird dabei der Reinraumatmosphäre nicht ausgesetzt.

Es folgt eine Abscheidung vom Polysilizium 161 zum Auffüllen des Grabens 108 und zum Verbinden desselben mit der Grenzfläche 201 im oberen Bereich des Kragens 108. Das Füll-Polysilizium 161 ist, wie erwähnt, üblicherweise mit As, P mit einer Konzentration von 10¹⁹ cm⁻³ - 10²¹ cm⁻³ dotiert. Letzlich wird das Füll-Polysilizium 161 planarisiert und z.B. ca. 50 nm unter die Substratoberfläche eingesenkt, um so zum in Figur lld gezeigten Prozeßstadium zu gelangen. Die weiteren Prozeßschritte sind derart, wie im Zusammenhang mit der Variante nach Figur 7g geschrieben.

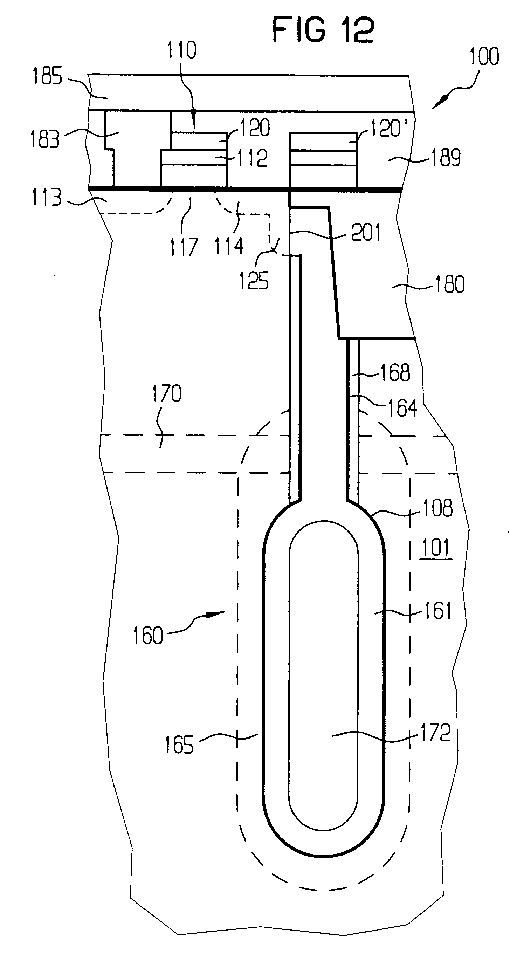

Fig. 12 zeigt ein weiteres Beispiel einer üblichen DRAM-Zelle entsprechend einer weiteren Verfahrensvariante. In Analogie zu Figur 8 kann die letztere Variante nämlich auch für einen flaschenförmigen Graben 108 verwendet werden, was gerade in Figur 12 illustriert ist.

Die besonderen Vorteile dieser beiden letzteren Varianten liegen darin, daß eine Grabenzelle mit vergrabenem Kontakt bereitgestellt wird, welche nur eine Grenzfläche, z.B. Polysilizium/Einkristall-Silizium, aufweist, wohingegen üblicherweise mindestens zwei Grenzflächen vorgesehen sind.

Die besonderen Schritte dieser beiden Varianten sind das Bilden des Kragens vor der Abscheidung des Speicherdielektrikums und das Definieren des vergrabenen Kontakts mit einem Fotolack-Einsenkprozeß, wobei selbstverständlich jedes andere geeignete Material anstelle des Lackes verwendet werden kann, welches selektiv zum Kragen (Oxid), Dielektrikum (Nitrid) und Substrat (Silizium) entfernbar ist, beispielsweise As- oder P-dotiertes Polysilizium, die mittels CDE selektiv zu Oxid, Nitrid und undotiertem oder p-dotiertem Silizium ätzbar sind.

Problematisch bei allen angeführten bekannten Varianten ist die Bildung des Anschlusses des Kondensators an der Grenzfläche 201 zwischen dem Kondensatoranschlußdiffusionsbereich 125 und der vergrabenen Brücke 162 bzw. dem Füll-Polysilizium 161. Etwaige Fehler bzw. Störungen in diesem Anschlußbereich können einen erhöhten Übergangswiderstand und damit Fehler bei Schreib/ Lesezyklen verursachen.

Zum Vermeiden von Fehlern und der damit verbundenen Ausfälle bietet sich der Einbau einer Grenzschicht , wie z.B. aus thermischem Oxid, Nitrid oder Oxinitrid, an der Grenzfläche 201 an.

Verwendet man eine dünne Grenzschicht, bricht diese bei nachfolgenden thermischen Prozessen von typischerweise 1100 °C (z.B. Oxidation nach Ätzen der STI-Gräben) leicht auf, was zu unkontrollierter Siliziumrekristallisation und entsprechenden Versetzungen an der Grenzfläche 201 führt. Es kommt zu Kurzkanaleffekten oder Punchthrough des Auswahltransistors (Ausdiffusion wird zu stark) und zu einer ungewünschten Verringerung der Retention Time (Haltezeit).

Verwendet man eine dicke Grenzschicht, die bei nachfolgenden thermischen Prozessen nicht aufbricht, unterdrückt diese die Ausdiffusion und verschlechtert die Kontaktierung wegen eines erhöhten Übergangswiderstands und damit verbundenen Fehlern bei den Schreib/Lesezyklen.

Daher ist die übliche Lösung mit Ausdiffusion durch die Grenzfläche 201 unbefriedigend, weil sich die Kontaktierung des Auswahltransistors nur schlecht kontrollieren läßt.

Die Aufgabe der vorliegenden Erfindung besteht daher darin, einen verbesserten Grabenkondensator mit einem Isolationskragen zu schaffen, welcher eine besser kontrollierbare Kontaktierung aufweist. Eine weitere Aufgabe der Erfindung liegt in der Bereitstellung eines entsprechenden Herstellungsverfahrens.

Erfindungsgemäß wird diese Aufgabe durch den in Anspruch 1 angegebenen Grabenkondensator mit einem Isolationskragen gelöst.

Weiterhin wird diese Aufgabe durch das in Anspruch 6 angegebene Verfahren gelöst.

Bevorzugte Weiterbildungen sind Gegenstand der jeweiligen Unteransprüche.

Der erfindungsgemäße Grabenkondensator bzw. das erfindungsgemäße Herstellungsverfahren weisen gegenüber den bekannten Lösungsansätzen den Vorteil auf, daß der Widerstand an der Grenzfläche 201 stark erniedrigt ist. Insbesondere sind die Ausfälle aufgrund von unterschiedlicher Haltezeit reduziert und gleichzeitig die Prozeßausbeute erhöht. Die Möglichkeit, die Grabenzelle zu verkleinern ist erhöht, da der Kontakt mit dem Matrixtransistor nicht durch Ausdiffusion von As und P von dem vergrabenen Streifen durchgeführt wird, sondern durch direkte Dotierung (Ionenimplantation, PLAD oder PIII, Gasphasendotierung) und somit die Übergangstiefe von größer 100 nm auf kleiner 50 nm an dem vergrabenen Kontakt zwischen vergrabener Brücke 162 und dem Substrat 101 vermindert werden kann. Kurzkanaleffekte und Punchthrough des Auswahltransistors bzw. Matrixtransistors sind somit vermeidbar.

Die der vorliegenden Erfindung zugrundeliegende Idee liegt in der Implantation (bzw. Plasmadotierung oder Gasphasendiffusion) durch die Grenzfläche 201 und der Bildung einer optionalen dicken Grenzschicht als Tunnelkontakt, welche während der folgenden Prozeßschritte nicht aufbricht und somit keine Versetzungsbildung ermöglicht.

Eine Nitridbarriere (Barrierenhöhe 2 eV) ist einer Oxidbarriere (Barrierenhöhe 3,5 eV) wegen des höheren Tunnelstroms bei gleicher Dicke vorzuziehen. Auch die Bildung einer dünneren Oxinitridschicht ist möglich.

Nitrid oder Oxinitrid können thermisch gebildet werden oder mittels (LP)CVD-Abscheidung oder Kombination aus thermischem Wachstum und CVD-Abscheidung oder CVD-Abscheidung mit thermischer Verdichtung.

Ausführungsbeispiele der vorliegenden Erfindung sind in den Zeichnungen dargestellt und in der nachfolgenden Beschreibung näher erläutert.

In den Figuren zeigen:
- Fig. 1: ein Ausführungsbeispiel einer DRAM-Zelle gemäß der vorliegenden Erfindung entsprechend einer ersten Ausführungsform des erfindungsgemäßen Verfahrens;
- Fig. 2a,b: die erste Ausführungsform des erfindungsgemäßen Verfahrens zur Herstellung der DRAM-Speicherzelle nach Fig. 1;
- Fig. 3: ein weiteres Ausführungsbeispiel einer DRAM-Zelle gemäß der vorliegenden Erfindung entsprechend einer zweiten Ausführungsform des erfindungsgemäßen Verfahrens;
- Fig. 4a,b: die zweite Ausführungsform des erfindungsgemäßen Verfahrens zur Herstellung der DRAM-Speicherzelle nach Fig. 3;
- Fig. 5: ein weiteres Ausführungsbeispiel einer DRAM-Zelle gemäß der vorliegenden Erfindung entsprechend einer dritten Ausführungsform des erfindungsgemäßen Verfahrens;
- Fig. 6: ein Beispiel einer üblichen DRAM-Zelle;
- Fig. 7a-g: eine Variante des Verfahrens zur Herstellung der DRAM-Speicherzelle nach Fig. 6;
- Fig. 8: ein weiteres Beispiel einer üblichen DRAM-Zelle;
- Fig. 9: ein weiteres Beispiel einer üblichen DRAM-Zelle;
- Fig. 10: ein weiteres Beispiel einer üblichen DRAM-Zelle;
- Fig. 11a-d: eine Variante des Verfahrens zur Herstellung der DRAM-Speicherzelle nach Fig. 10; und
- Fig. 12: eine weiteres Beispiel einer üblichen DRAM-Zelle.

In den Figuren bezeichnen gleiche Bezugszeichen gleiche oder funktionsgleiche Elemente.

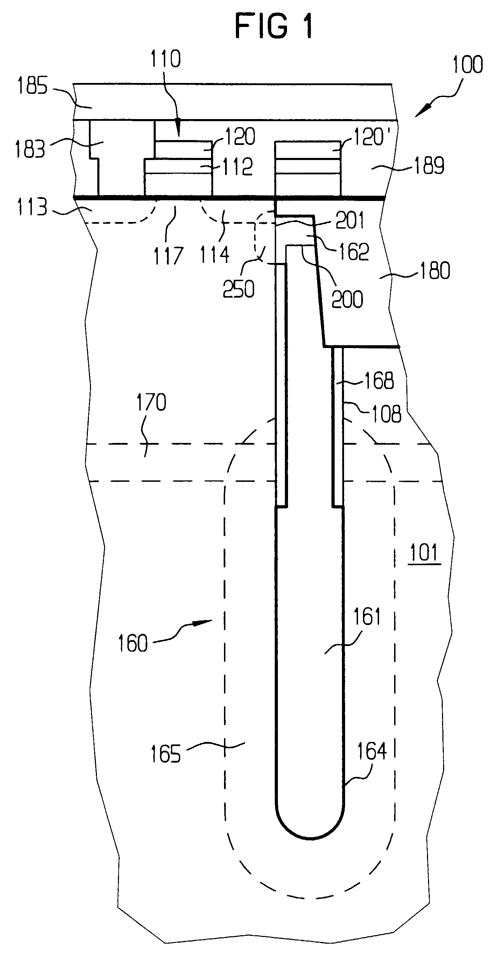

Fig. 1 zeigt ein Ausführungsbeispiel einer DRAM-Zelle gemäß der vorliegenden Erfindung entsprechend einer ersten Ausführungsform des erfindungsgemäßen Verfahrens.

Mit Bezug auf Fig. 1 ist bei diesem Ausführungsbeispiel der DRAM-Zelle anstelle des Kondensatoranschlußdiffusionsbereichs 125 ein vorzugsweise durch schräge Implantation hergestellter Implantationsbereich 250 (z.B. As oder P) an der Grenzfläche 201 zwischen der vergrabenen Brücke 162 und dem Substrat 101 vorgesehen. Dieser Implantationsbereich 250 wird vor dem Aufwachsen der Grenzflächenschicht (beispielsweise Nitrid, Oxinitrid oder Oxid) durchgeführt. Alternativermaßen können ein isotroper Dotierungsprozeß, wie z.B. eine Plasmadotierung (PLAD) oder Plasmaimmersions-Ionenimplantation (PIII) oder eine Gasphasendotierung anstelle der schrägen Implantation verwendet werden. Das PLAD-Verfahren oder das PIII-Verfahren sind bevorzugt, da sie die Bildung von sehr flachen Übergängen erlauben.

Auch eine Implantation nach Ausbildung der Grenzflächenschicht ist möglich. In diesem Fall dient die Grenzfläche als Streuschicht.

Im allgemeinen ermöglicht diese Ausführungsform die Reduzierung der Übergangstiefe des Kontaktbereichs für den Übergang von der vergrabenen Brücke 162 zum Substrat 101, was zur Vermeidung von Kurzkanaleffekten und eines Punchthrough der betreffenden Matrixvorrichtung bzw. des Auswahltransistors sehr wichtig ist.

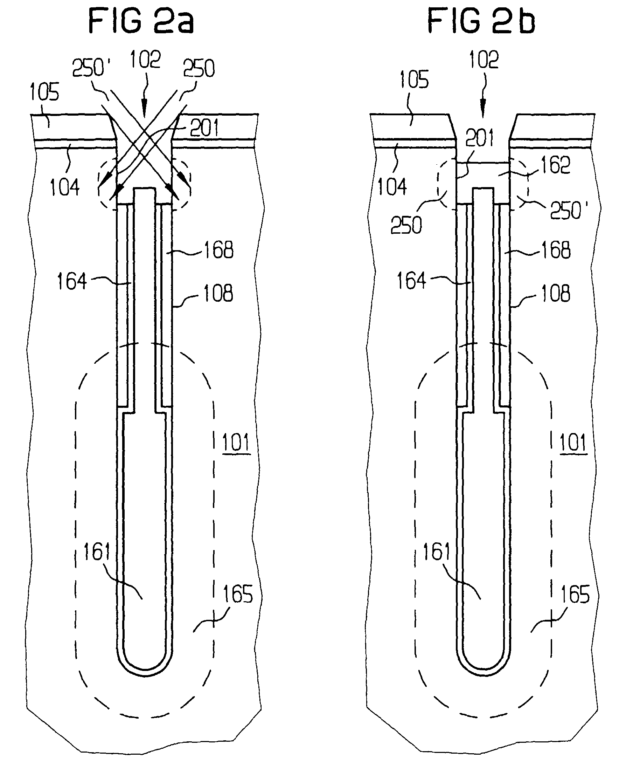

Fig. 2a,b zeigen die Ausführungsform des erfindungsgemäßen Verfahrens zur Herstellung der DRAM-Speicherzelle nach Fig. 1.

Wie in Fig. 2a gezeigt, welche dem Prozeßstadium von Figur 7e vor Aufbringung der vergrabenen Brücke 162 entspricht, wird - nach optioneller Abscheidung eines Streuoxids von beispielsweise 5 nm Dicke zur Vermeidung einer Beschädigung des Substratsiliziums während der Implantationen - eine schräge Implantation, beispielsweise mit As, P oder Sb, vorzugsweise mit As, durchgeführt, um den Implantationsbereich 250 bzw. 250' zu bilden. Der Grund dafür, daß beide Seiten implantiert werden liegt darin, daß von zwei nebeneinanderliegenden Grabenkondensatoren 160 in der Regel der linke an der linken Grabenseite und der rechte an der rechten Grabenseite angeschlossen wird, wobei sie sich einen STI-Isolationsgraben 180 teilen.

Falls ein Streuoxid aufgebracht wurde, wird es anschließend beispielsweise durch eine Naßätzung BHF entfernt.

Anschließend erfolgt eine Vorreinigung (z.B. naßchemisch (DHF, BHF) oder in situ (H₂-Prebake, HF-Dampf, HF/NH₃-Dampf, UHV-Anneal), und dann wird die Grenzfläche 201 konditioniert, beispielsweise durch thermisches Aufwachsen von Siliziumnitrid (780°, 30 Minuten, NH₃, 1 Torr) oder Siliziumoxynitrid oder Siliziumoxid mit einer Dicke im Bereich von 0,5-2 nm, vorzugsweise 0,8-1,5 nm. Dabei ist Nitrid bevorzugt wegen seiner geringen Barrierenhöhe von 2 eV gegenüber von Oxid mit 3,5 eV für Elektronentunnelströme.

Auch eine (LP)CVD-Abscheidung ist möglich, aber eine thermische Bildung oder eine Kombination aus CVD-Abscheidung und thermischer Verdichtung ist bevorzugt.

Anschließend wird, wie in Fig. 2b gezeigt, der Graben 108 mit dem Polysilizium 161 gefüllt, letzteres planarisiert und eingesenkt und schließlich die vergrabene Brücke 162 in Form von Polysilizium in situ mit einer As- oder P-Dotierung größer 1x10¹⁹ cm⁻³ gebildet. Ebenfalls ist eine nachträgliche Dotierung der vergrabenen Brücke 162 möglich.

Darauf folgend wird das Verfahren fortgesetzt, wie in Zusammenhang mit Figur 7g beschrieben.

Ebenfalls möglich ist im übrigen eine isotrope Implantation, wobei in diesem Fall auch das obere Ende des eingesenkten Polysiliziums 161 implantiert wird.

Schließlich kann anstelle einer Implantation auch eine Gasphasendotierung (z.B. 900-1100°C, 1 min., 760 Torr mit AsH₃ oder PH₃ oder 800-1050 °C mit AsH₃ oder PH₃ in einem Vertikalofen) zweckmäßigerweise ohne Streuoxid, welches als Diffusionsbarriere wirken würde, durchgeführt werden.

Während eine Implantation, PLAD oder PIII die Bildung besonders flacher Bereich 250 ermöglichen, kann eine Gasphasendotierung in situ und ohne Streuoxid vor der Bildung der Grenzflächenschicht ausgeführt werden und bietet somit den Vorteil hoher Produktivität.

Diese Ausführungsform bietet weiterhin den Vorteil, daß der Widerstand an der Grenzfläche 201 stark erniedrigt ist. Insbesondere sind die Ausfälle aufgrund von unterschiedlicher Haltezeit reduziert und gleichzeitig die Prozeßausbeute erhöht. Die Möglichkeit, die Grabenzelle zu verkleinern ist erhöht, da der Kontakt mit dem Matrixtransistor nicht durch Ausdiffusion von As und P von dem vergrabenen Streifen durchgeführt wird, sondern durch Implantation (Ionenimplantation, PLAD oder PIII, Gasphasendotierung) und somit die Übergangstiefe von größer 100 nm auf kleiner 50 nm an dem vergrabenen Kontakt zwischen vergrabener Brücke 162 und dem Substrat 101 vermindert werden kann. Kurzkanaleffekte und Punchthrough des Auswahltransistors und des parasitären Vertikaltransistors sind somit vermeidbar.

Die Kombination einer hinreichend dicken Grenzflächenschicht 102 zur Verhinderung der Ausdiffusion des vergrabenen Streifens 162 und der Versetzungsbildung an der vergrabenen Brükke 162 in Kombination mit einer flachen Implantation bilden einen besonders guten vergrabenen Kontakt zwischen dem Transistor 110 und dem Grabenkondensator 160.

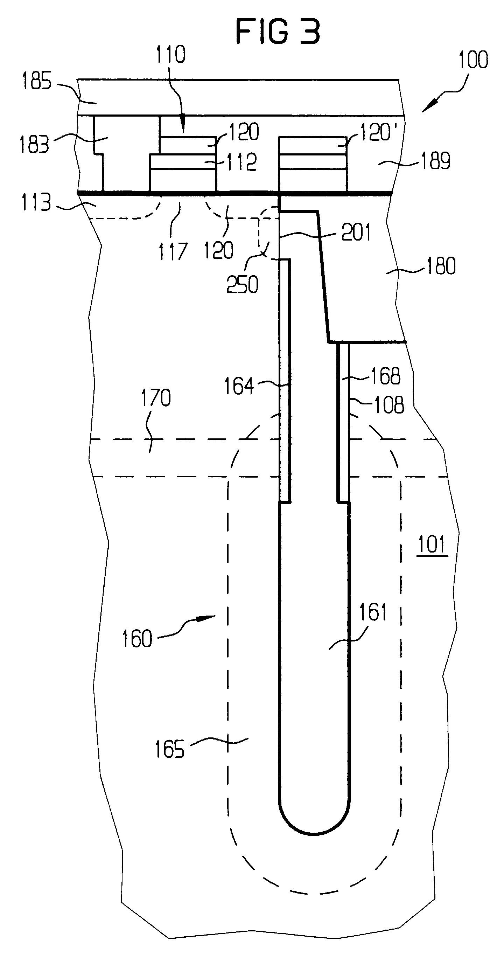

Fig. 3 zeigt ein weiteres Ausführungsbeispiel einer DRAM-Zelle gemäß der vorliegenden Erfindung entsprechend einer zweiten Ausführungsform des erfindungsgemäßen Verfahrens.

Wie in Fig. 3 illustriert, baut die zweite Ausführungsform auf die in Figur 10 gezeigte bekannte Variante auf, wobei ebenfalls wie bei der ersten Ausführungsform anstelle des Diffusionsbereichs 125 der Implantationsbereich 250 vorgesehen ist.

Fig. 4a,b zeigen die zweite Ausführungsform des erfindungsgemäßen Verfahrens zur Herstellung der DRAM-Speicherzelle nach Fig. 3.

Mit Bezug auf Fig. 4a, welche dem in Figur llc gezeigten Prozeßstadium entspricht, wird die schräge Implantation durchgeführt, wie in Zusammenhang mit der ersten Ausführungsform beschrieben. Anschließend erfolgt, wie in Fig. 4b gezeigt, die Füllung mit Polysilizium 161 und das Einsenken des Polysiliziums ca. 50 nm unterhalb der Substratoberfläche.

Die weiteren Verfahrensschritte verlaufen so, wie in Zusammenhang mit Figur 7g beschrieben.

In diesem Zusammenhang sei weiterhin noch erwähnt, daß die erste und zweite Ausführungsform auch bei einem Grabenkondensator anwendbar sind, welcher herstellungsgemäß eine weitere Grenzfläche 202 zwischen dem unteren Teil des Grabens 108 und dem oberen Teil des Grabens 108 aufweist, nämlich an der Unterseite des Kragens 168 (vgl. Fig. 9).

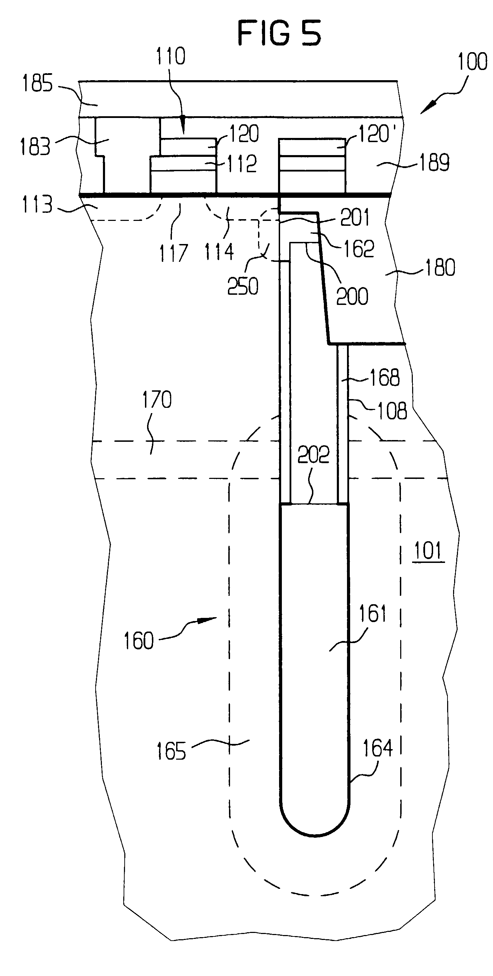

Eine solche Struktur ist in Fig. 5 gezeigt, die ein weiteres Ausführungsbeispiel einer DRAM-Zelle gemäß der vorliegenden Erfindung entsprechend einer dritten Ausführungsform des erfindungsgemäßen Verfahrens illustriert.

Obwohl die vorliegende Erfindung vorstehend anhand bevorzugter Ausführungsbeispiele beschrieben wurde, ist sie darauf nicht beschränkt, sondern auf vielfältige Art und Weise modifizierbar.

Insbesondere sind die angeführten Materialien nur beispielhaft und durch andere Materialien mit geeigneten Eigenschaften ersetzbar. Dasgleiche gilt für die genannten Reinigungs- und Dotier-, thermischen Aufwachs- und/oder Abscheidungsprozesse.

Obwohl als die Tunnelschicht insbesondere eine Oxid-, Nitrid- oder Oxinitridschicht genannt wurden, ist prinzipiell jede Schicht geeignet, die während der thermischen Prozeßschritte von typischerweise 1100 °C nicht aufbricht, aber einen möglichst hohen Tunnelstrom erlaubt.

Auch sind die gezeigten Ausführungsformen miteinander kombinierbar, was die Abfolge der Prozeßschritte betrifft.

## Patentansprüche

1. Grabenkondensator, insbesondere zur Verwendung in einer Halbleiter-Speicherzelle (100), mit einem Isolationskragen (168) mit:
einem Graben (108), der in einem Substrat (101) gebildet ist;
dem Isolationskragen (168), der im oberen Bereich des Grabens (108) gebildet ist;
einer optionellen vergrabenen Platte (165) im Substratbereich in der Umgebung des unteren Bereichs des Grabens (108) als erste Kondensatorplatte;
einer dielektrischen Schicht (164) zur Verkleidung des unteren Bereichs des Grabens (108) und des Isolationskragens (168) als Kondensatordielektrikum;
einem in den Graben (108) gefüllten leitenden zweiten Füllmaterial (161) als zweite Kondensatorplatte; und
einem vergrabenen Kontakt unterhalb der Oberfläche des Substrats (101);
dadurch **gekennzeichnet**, daß
das Substrat (101) unterhalb seiner Oberfläche im Bereich des vergrabenen Kontakts einen durch Implantation, Plasmadotierung und/oder Gasphasenabscheidung eingebrachten Dotierbereich (250; 250') aufweist.

2. Grabenkondensator nach Anspruch 1, dadurch gekennzeichnet, daß oberhalb des Isolationskragens (168) auf dem leitenden zweiten Füllmaterial (161) eine Brücke (162) aus einem dritten leitenden Füllmaterial gebildet ist.

3. Grabenkondensator nach Anspruch 1 oder 2, dadurch gekennzeichnet, daß der Graben (108) eine flaschenartige Form aufweist und im verbreiterten Bereich ein Hohlraum (172) des leitenden zweiten Füllmaterials (161) ausgebildet ist.

4. Grabenkondensator nach Anspruch 1 oder 3, dadurch gekennzeichnet, daß das leitende zweite Füllmaterial (161) oberhalb des Isolationskragens (168) eine Brücke (162) zum vergrabenen Kontaktes mit dem Substrat (101) bildet.

5. Grabenkondensator nach einem der Ansprüche 1 bis 4, dadurch gekennzeichnet, daß an der Grenzfläche (201) des vergrabenen Kontakts eine Tunnelschicht, insbesondere eine Oxid-, Nitrid- oder Oxinitridschicht, gebildet ist.

6. Verfahren zur Herstellung eines Grabenkondensators, insbesondere zur Verwendung in einer Halbleiter-Speicherzelle (100), mit einem Isolationskragen (168) mit den Schritten:
Bilden eines Grabens (108) in einem Substrat (101);
Füllen des unteren Bereichs des Grabens (108) mit einem ersten Füllmaterial (152);
Bilden des Isolationskragens (168) im oberen Bereich des Grabens (108);
Entfernen des ersten Füllmaterials (152) aus dem unteren Bereich des Grabens (108);
optionelles Bilden einer vergrabenen Platte (165) im Substratbereich in der Umgebung des unteren Bereichs des Grabens (108) als erste Kondensatorplatte;
Bilden einer dielektrischen Schicht (164) zur Verkleidung des unteren Bereichs des Grabens (108) und der Innenseite des Isolationskragens (168) als Kondensatordielektrikum; und
Füllen des Grabens (108) mit einem leitenden zweiten Füllmaterial (161) als zweite Kondensatorplatte
**gekennzeichnet** durch den Schritt
des Einbringens eines Dotierstoffs in das Substrat (101) unterhalb seiner Oberfläche im Bereich des vergrabenen Kontakts durch Implantation, Plasmadotierung und/oder Gasphasenabscheidung.

7. Verfahren nach Anspruch 6, dadurch gekennzeichnet, daß der Dotierstoff durch eine schräge oder isotrope Implantation durch die freigelegte oder mit einem Streuoxid versehene Grenzfläche (201) eingebracht wird.

8. Verfahren nach Anspruch 7, dadurch gekennzeichnet, daß an der Grenzfläche (201) des vergrabenen Kontakts eine Tunnelschicht, insbesondere eine Oxid-, Nitrid- oder Oxinitridschicht, gebildet wird.

9. Verfahren nach Anspruch 6, dadurch gekennzeichnet, daß der Dotierstoff durch eine Gasphasendotierung, insbesondere 1100°C, 1 min., 760 Torr mit AsH₃ oder PH₃, durch die freigelegte Grenzfläche (201) eingebracht wird.

10. Verfahren nach einem der Ansprüche 6 bis 9, gekennzeichnet durch den Schritt des Bildens einer Brücke (162) oberhalb des Isolationskragens (168) auf dem leitenden zweiten Füllmaterial (161) aus einem dritten leitenden Füllmaterial zum vergrabenen Kontaktes.

11. Verfahren nach einem der Ansprüche 6 bis 10, gekennzeichnet durch die Schritte Füllen des mit dem Isolationskragen (168) und der dielektrischen Schicht (164) ausgekleideten Grabens (168) mit einem vierten Füllmaterial (210), welches selektiv gegenüber dem Substrat (101), dem Isolationskragen (168) und der dielektrischen Schicht (164) entfernbar ist; Einsenken des vierten Füllmaterials (210), des Isolationskragens (168) und der dielektrischen Schicht (164) zum Definieren einer Grenzfläche (202) des vergrabenen Kontakts zum Substrat; Entfernen des vierten Füllmaterials (210); und Auffüllen des Grabens (108) mit dem leitenden zweiten Füllmaterial (161).

12. Verfahren nach einem der Ansprüche 6 bis 11, gekennzeichnet durch den Schritt des Erweiterns des unteren Bereichs des Grabens (108) gegenüber dem oberen Bereich des Grabens (108) zum Bilden einer Flaschenform.

13. Speicherelement, insbesondere DRAM-Speicherzelle, mit einem Grabenkondensator nach mindestens einem der Ansprüche 1 bis 5 und einem damit über den vergrabenen Kontakt verbundenen Auswahlransistor.
